# EUROPEAN PATENT APPLICATION

(11) **EP 4 621 990 A1**
(43) Date of publication of application: **24.09.2025**
(21) Application number: 24165619.8
(22) Date of filing: 22.03.2024
(51) Int. Cl.: H01Q 1/22, H01Q 13/10, H01Q 21/00, H01Q 13/06

(54) **ANTENNA ASSEMBLY WITH STACK AND ANTENNA STRUCTURE**

(71) Applicant: AT & S Austria Technologie & Systemtechnik Aktiengesellschaft, 8700 Leoben (AT)
(72) Inventor: HEIMRATH, Roland, 8741 Weisskirchen (AT); VOCKENBERGER, Christian, 8700 Leoben (AT); EBNER, Claudia, 8583 Edelschrott (AT); GOESSLER, Michael, 8723 Kobenz (AT); GROBER, Gernot, 8741 Weißkirchen (AT); SCHLAFFER, Erich, 8642 St. Lorenzen (AT); SCHLICK, Daniel, 8733 St. Marein-Feistritz (AT); CANDIC, Kenad, 8041 Graz (AT); ALOTHMAN ALTERKAWI, Ahmad Bader, 8020 Graz (AT); TAKAHASHI, Hiroaki, 1090 Wien (AT)
(74) Representative: Dilg, Haeusler, Schindelmann Patentanwaltsgesellschaft mbH

(57) **Abstract**

There is described an antenna assembly (100) comprising:
i) a stack (110) comprising:
ia) at least one electrically conductive layer structure (104) and at least one electrically insulating layer structure (102), wherein at least a portion of said electrically conductive layer structure (104, 115) is provided at the external side of the stack (110) and is configured to act at least as part of an electromagnetic wave coupling structure (115); and
ib) a component (130), at least partially embedded in the stack (110), and coupled to said electromagnetic wave coupling structure (115); and

ii) an antenna structure (120), comprising an opening (125) to a channel (121) passing through the antenna structure (120).

The stack (110) and the antenna structure (120) are connected, so that the electromagnetic wave coupling structure (115) and the opening (125) to the channel (121) face each other.

## Description

### Field of the Invention

The invention relates to an antenna assembly comprising a stack mounted on an antenna structure. The stack comprises at a surface an electromagnetic wave coupling structure arranged to face an opening at the surface of the antenna structure. Said opening leads to a channel that extends through the antenna structure, which is in particular configured as a wave guide. Further, a method to manufacture the antenna assembly is described.

Accordingly, the invention may relate to the technical field of component carriers, such as printed circuit boards or IC substrates, and their manufacture, in particular with respect to radio frequency applications.

### Technical Background

In the context of growing product functionalities of component carriers equipped with one or more electronic components and increasing miniaturization of such electronic components as well as a rising number of electronic components to be mounted on the component carriers such as printed circuit boards, increasingly more powerful array-like components or packages having several electronic components are being employed, which have a plurality of contacts or connections, with ever smaller spacing between these contacts. Removal of heat generated by such electronic components and the component carrier itself during operation becomes an increasing issue. Also an efficient protection against electromagnetic interference (EMI) becomes an increasing issue. At the same time, component carriers shall be mechanically robust and electrically and magnetically reliable so as to be operable even under harsh conditions.

Radio frequency (RF) applications have become more and more important in the field of component carriers. For example, antenna (e.g. patch, slot, or waveguide antennas) or radar applications can be implemented in or coupled to component carriers. Yet, these important applications may still be seen as a challenge with respect to signal quality and space requirements, in particular regarding waveguide antennas.

Conventionally, waveguide antennas are assembled onto circuit boards (surface-mounted). Due to the distance between the circuit board and the waveguide antenna, signal losses cannot be avoided, thereby lowering the signal quality. An integration on module level (e.g. a radar frontend) can be done by using coupling structures, so called launchers, to feed the electromagnetic signal (RF signal) into the waveguide. Launchers can be seen as radiating elements capable of emitting an RF signal (similar for example to antenna patches). Two different configurations are generally known hereby: i) the launcher is applied on board-level known as launcher on board (LoB) or ii) the launcher is applied on package-level known as launcher in package (LiP).

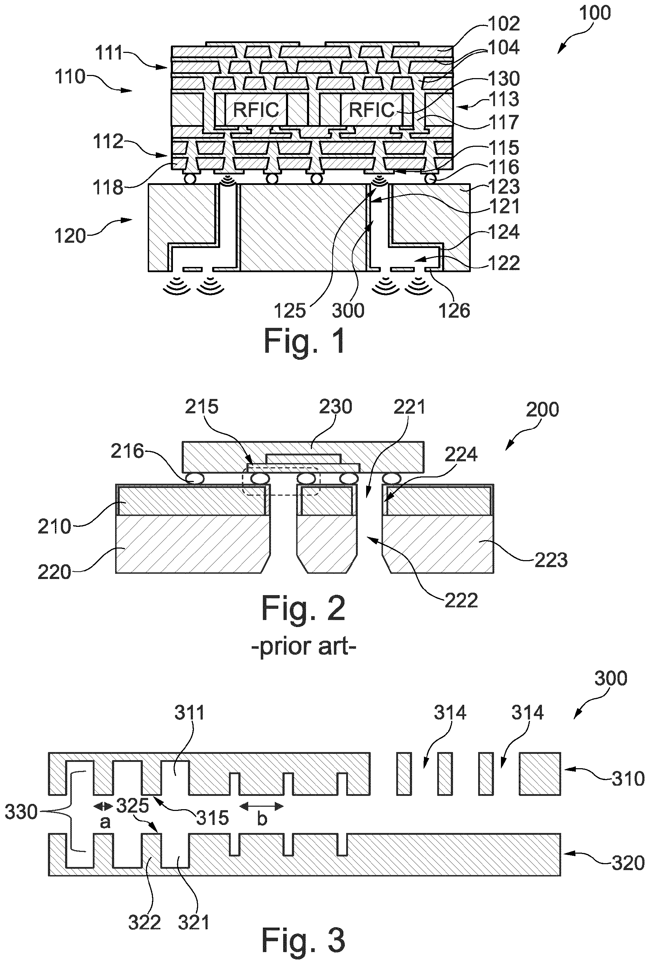

**Figure 2** shows an example of such a conventional antenna module 200 (here launcher in package). A circuit board 210 serves as a mounting structure for the RF chip 230. The RF chip 230 is surface-mounted to the circuit board 210 and interconnected by solder balls 216. Directly below the circuit board 210, there is arranged an antenna waveguide module 220 that comprises vertical waveguide channels 222. The circuit board 210 comprises through-holes 221 (cut-out) that correspond to the vertical waveguide channels 222, respectively, in the vertical direction (in other words: the through-holes elongate the respective waveguide channels 222). The sidewalls of the through-holes and/or waveguide are metallized (e.g. plated through-holes). The RF chip 230 further comprises a launcher 215, arranged at the lower main surface of said RF chip 230. Thus, a launcher in package configuration is applied here. The launcher 215 emits the RF signal and thereby feeds said RF signal via the through-holes 221 into the waveguide channels 222. The waveguide channels 222 elongate through the circuit board 210 and the antenna waveguide module 220.

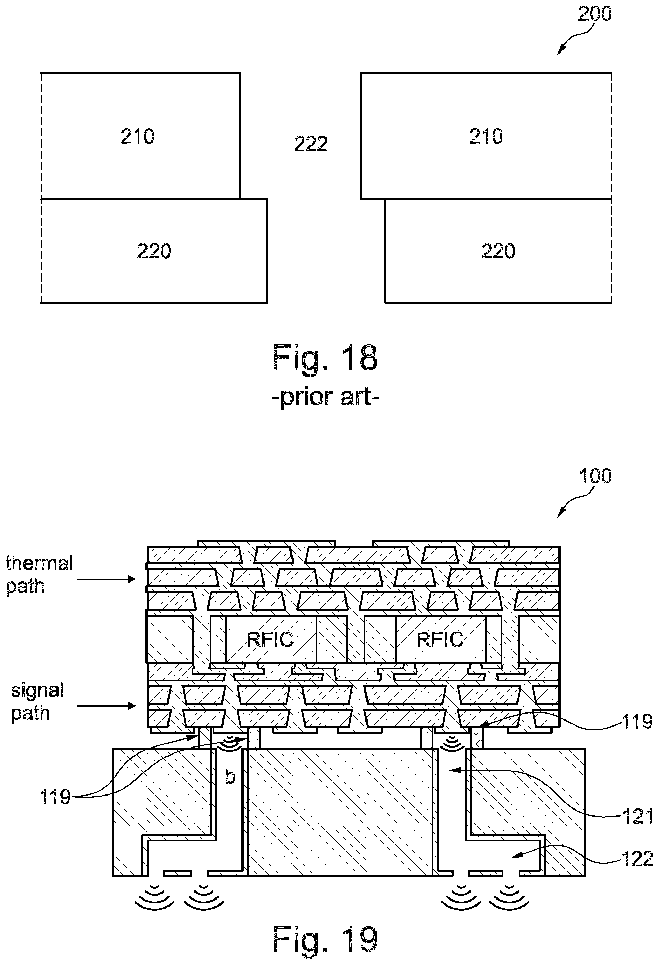

**Figure 18** shows a drawback of such a conventional antenna module 200. The module 210 and 220 are separate structure assembled together. Hereby, during the manufacture process, a step-like structure can be formed at the interface of the modules 210, 220. The assembly process can be seen as a major drawback of conventional antenna modules. Each shift in any direction (x/y/z) will lead to performance loss.

A launcher can further be a (quite) large space-consuming structure. For example, a launcher structure (e.g. for 77GHz) applied on to conventional chip package (not embedded die), may significantly increase the size (especially the area) of the IC package.

Further, packaging materials have generally no reinforcements such as glass fibers. As the RF chip (normally a bare die) does not increase in size, the packaging might suffer from low mechanical stability. Material properties may further show a poor RF-performance. In the case of a launcher on board configuration, the interconnecting solder balls (ball grid array, BGA) may cause losses (in terms of cut-off frequency limitations).

It may be desired to increasing the amount of antennas and RF channels in the module respectively (e.g. for radar applications) which would require the implementation of several RF chips (chip cascading). But then, the size of the module would also increase. Further, there may be a need to increase the signal quality.

### Summary of the Invention

There may be a need to provide an efficient, reliable, and compact component carrier based antenna assembly.

An antenna assembly and a method of manufacturing are described.

According to a first aspect of the invention, there is described an antenna assembly comprising:
i) a (multilayer) stack (e.g. a component carrier such as a printed circuit board) comprising:
   ia) at least one electrically conductive layer structure (e.g. copper traces) and at least one electrically insulating layer structure (e.g. a resin layer), wherein at least a portion of said electrically conductive layer structure (e.g. an exposed copper pad/trace) is provided at the external side of the stack (in particular exposed) and is configured to act at least as part of an electromagnetic wave coupling structure (in particular a launcher); and
   ib) a component (e.g. an RFIC), at least partially embedded in the stack, and coupled to said electromagnetic wave coupling structure (e.g. via a redistribution layer structure); and
ii) an antenna structure (e.g. a block or a layer stack), comprising an opening to a channel (in particular a wave guide) passing through the antenna structure (e.g. from a first main surface to an opposed second main surface).

Hereby, the stack and the antenna structure are connected (e.g. via electric connections such as solder balls), so that the electromagnetic wave coupling structure and the opening to the channel face each other (and electromagnetic waves from the electromagnetic wave coupling structure can be directly coupled into said opening/channel).

According to a second aspect of the invention, there is described a method of manufacturing an antenna assembly, the method comprising:
i) providing a stack comprising: at least one electrically conductive layer structure and at least one electrically insulating layer structure (e.g. by lamination), wherein at least a portion of said electrically conductive layer structure is provided at the external side of the stack and is configured to act at least as part of an electromagnetic wave coupling structure;
ii) at least partially embedding a component in the stack and coupling the component to said electromagnetic wave coupling structure;
iii) providing an antenna structure, comprising an opening to a channel passing through the antenna structure; and
iv) connecting the stack and the antenna structure, so that the electromagnetic wave coupling structure and the opening to the channel face each other.

In the present context, the term "electromagnetic wave coupling structure" may refer to a structure suitable to couple an electromagnetic wave (e.g. an RF signal) into a further structure, preferably an opening to a channel (such as a waveguide) of an antenna structure. In an embodiment, the electromagnetic wave coupling structure can be configured as a conductive layer structure, e.g. a pad or pillar comprising a metal, in particular copper, silver or gold. Additionally or alternatively, the electromagnetic wave coupling structure may comprise electrically insulating material, for example organic polymeric material, having a dielectric constant smaller than seven, in particular smaller than four. In a first embodiment, the electromagnetic wave coupling structure is configured as (a part of) an electrically conductive layer structure of the stack (in particular an external/outermost layer). In a second embodiment, the electromagnetic wave coupling structure can be configured as a surface finish (e.g. ENEPIG). In a preferred example, the surface finish may be Nickel-free (Ni-free may increase the performance). The electromagnetic wave coupling structure can have a comparable or smaller size (or larger size) (diameter) than the corresponding opening/channel. In an embodiment, the size may be in line with the waveguide entrance, e.g. the same. In an example, the launcher may be dependent from the square-root of Dk (e.g. if Dk is four, the launcher shows a size of half of the waveguides cross section).

In the present context, the term "antenna structure" may refer to a structure suitable to implement an antenna (related) functionality. Such an antenna structure may be configured e.g. as a block or a (component carrier) stack. When the antenna structure is configured as (part of) a component carrier, the antenna structure may have less than seven layers, in particular less than five layers, more in particular three layers (or less). In an embodiment, the antenna structure comprises an opening to a channel, preferably a channel going through the antenna structure. Such a channel may serve as a waveguide to guide an electromagnetic wave (e.g. provided by a launcher) at least partly within and/or through the antenna structure. For this purpose, the (side) walls of the channel may be (at least partially) coated/metallized.

Preferably, the coating of the side walls of the channel may be electrically conductive. Electrically conductive coating material may comprise a metal, e.g. copper or silver, which may bring the advantage of lower losses of electromagnetic waves when passing through the channel. Alternatively, the coating may comprise electrically insulating material. The antenna structure may be further configured to serve as a mounting structure for a (component carrier) stack. In an embodiment, the antenna structure comprises a plurality of said openings/channels (in the horizontal direction) next to each other. These channels may be separated from each other or (at least partially) interconnected.

In the present context, the term "face each other" may refer to the orientation/alignment of the stack and the antenna structure with respect to each other. In particular, said term may refer to the orientation/alignment of the electromagnetic waves coupling structure and the opening (to the channel) with respect to each other. In a first embodiment, the opening and the electromagnetic waves coupling structure each have a center point/geometrical barycenter one aligned with the other along the stack thickness direction (vertical direction Z). A deviating tolerance may hereby be smaller than 20 µm. A misalignment may be dependent on the applied frequency. In conventional examples, the misalignment may be 50 µm or more (at a frequency of e.g. 77 GHz). Coupling structure can be, for example, patch-like, dipole-like, slot-like etc. In a second embodiment, the opening and the electromagnetic waves coupling structure may each define an external planar surface, wherein said respective surfaces (at least partially) overlap (completely or partially) one to each other. Furthermore, the bottom side of the component carrier may be oriented towards the top side of the antenna structure.

In the present context, the term "component carrier" may refer to a final component carrier product as well as to a component carrier preform (i.e. a component carrier in production, in other words a semi-finished product). In an example, a component carrier preform may be a panel that comprises a plurality of semi-finished component carriers that are manufactured together. At a final stage, the panel may be separated into the plurality of final component carrier products.

In an embodiment, the component carrier "stack" comprises at least one electrically insulating layer structure and at least one electrically conductive layer structure. For example, the component carrier may be a laminate of the mentioned electrically insulating layer structure(s) and electrically conductive layer structure(s), in particular formed by applying mechanical pressure and/or thermal energy. The mentioned stack may provide a plate-shaped component carrier capable of providing a large mounting surface for further components. In an example, the stack may be nevertheless very thin and compact. In another example, the stack may be very thick for a high density product. The stacking direction (height/thickness) may be arranged in the vertical direction z. Further, the stacking direction may be perpendicular to the two directions of main extension (along x and y) of the (plate-shaped) component carrier.

In an example, all layers of the component carrier may form the stack. In another example, only a part of the layers of the component carrier form the stack.

In this context, the term "layer structure" may in particular refer to a continuous or discontinuous layer (or separated islands within the same plane) of electrically conductive or electrically insulating material. A plurality of such layers, parallel stacked one upon the other, may form the stack in the vertical direction.

In the context of the present application, the term "main surface" of a body may particularly denote one of two largest opposing surfaces of the body. The main surfaces may be connected by circumferential side walls. The thickness of a body, such as a stack, may be defined by the distance between the two opposing main surfaces.

According to an exemplary embodiment, the invention may be based on the idea that a component carrier based antenna assembly can be provided in an efficient, reliable, and compact manner, when a component carrier stack is mounted on an antenna structure. The stack comprises hereby an embedded component (preferably the RF component and/or a monolithic microwave integrated circuit (MMIC)) and an electrically conductive layer structure (connected to said embedded component) that at least partially forms an electromagnetic wave (RF signal) coupling structure that may serve as a launcher. The antenna structure comprises an opening to a (through) channel that may serve as the waveguide. Hereby, the stack is arranged on the antenna structure, so that the electromagnetic wave coupling structure faces the corresponding channel opening. In this manner, the RF signal emitted by the electromagnetic wave coupling structure may be directly fed into the channel of the antenna structure.

In comparison to conventional solutions (see e.g. Figure 2), two elements (stack and antenna structure) are sufficient for the RF application, thereby decreasing package size and efforts/costs. Additionally, the RF performance may be highly improved.

In an embodiment, the component carrier stack serves as the package, so that one element (carrier board) can be omitted. The stack comprises a layered build-up which may enable the use of reinforcements such as glass fibers or ceramic fillers, thereby increasing the mechanical reliability (no over mold necessary). More than one component (e.g. RF chip and processor), in particular different components, can be embedded in the stack (e.g. side-by-side) to increase the amount of RF channels and/or launchers, thereby enabling new interesting applications. The stack surface may further serve as an increased surface area for the application of a plurality of launcher structures, allowing for the manufacturing/ developing of scalable systems.

Furthermore, the antenna structure may be provided such that there is no shift/misalignment due to production tolerances in the waveguide channel (which leads to additional losses, compare Figure 18). In an example, such a shift-free channel may be provided by a metal structure channel.

### Exemplary Embodiments

In an embodiment, the channel vertically extends through the (entire) antenna structure. This may provide the advantage that the channel may be used to guide the emitted electromagnetic wave (from the coupling structure) directly to a specific application, e.g. a radar application. In a basic embodiment, the channel may be a straight opening (e.g. like a through-hole). In a further embodiment, the channel may comprise a more sophisticated shape through the antenna structure, e.g. an L-shape (see Figure 1) or a T-shape. The sidewalls of the channel may be partially or fully metallized and/or coated. In an example, the routing of channels insight the antenna structure can be done in different ways, preferably for implementing many channels on a small area. In an example, a short channel path may be preferred.

In an embodiment, the extremity of the channel (at the lower main surface of the antenna structure), opposed to the opening faced to the electromagnetic wave coupling structure, comprises an opening structure (in particular a slot), configured as a (electromagnetic) wave emitter or a (electromagnetic) wave receiver. This may provide the advantage that the electromagnetic wave can be efficiently guided to/from a specific application, by passing directly from the opening through the channel and exit the antenna structure at the opposing end of the channel (or the other way around). Said opposing end may comprise one or more slots (e.g. two slots in Figure 1) which may serve to emit and/or receive electromagnetic waves. Such an architecture may be suitable for radar applications, in particular when a plurality of openings are arranged next to each other.

In an embodiment, the extremity of the channel, opposed to the opening faced to the electromagnetic wave coupling structure, comprises an electrically conductive coupling layer structure comprising at least one aperture being in communication with the opening of the antenna structure. In this manner, the signal quality/performance may be improved. In the present context, the terms "opening" and "aperture" may refer to the same structure or to different structures. Specifically, an opening may be any opening at the extremity of the channel, while the aperture may refer to an opening in said electrically conductive coupling layer structure. The electrically conductive coupling layer structure may form part of the metallization of the channel walls. Yet, the electrically conductive coupling layer structure may also be an additional structure, e.g. provided by plating. The metallization may improve the electromagnetic wave transmission.

In an embodiment, the internal walls (sidewalls) of the at least opening (and/or aperture) on the antenna structure and/or the channel are coated by an electrically conductive material (or paramagnetic material), in particular a metal. In an embodiment, the internal walls of the at least opening (and/or aperture) on the antenna structure and/or the channel are coated by a material having a magnetic permeability in the range from 10⁻⁶ H/m to 10⁻⁵ H/m, preferably between 1.1*10⁻⁶ and 5*10⁻⁶. Thereby, the RF signal transmission quality/performance may be significantly improved.

In an embodiment, the antenna structure comprises a further stack comprising at least one further electrically conductive layer structure and at least one further electrically insulating layer structure. In this example, the antenna structure is also configured as a component carrier with a multilayer stack. This may provide the advantage that both, the stack and the further stack, can be manufactured in the same facility with similar/comparable materials and process steps, thereby saving costs/efforts. The build-up structure of such a stack may be suitable to embed components (to increase functionality) and/or reinforcement structures (to increase stability).

In an embodiment, the at least one further electrically conductive layer structure comprises the electrically conductive coupling layer structure. Thereby, the electrically conductive coupling layer structure (with the aperture) may be provided together with the further stack (essentially) without additional process steps.

In an embodiment, an antenna is located at least partially inside the further stack and/or on an external side of the further stack (in particular at the opposed side compared with the opening). Thereby, the functionality may be further increased. The antenna may be embedded in the further stack or surface-mounted to said further stack. In an embodiment, the antenna may be coupled to the channel (e.g. by a transmission line/stripline). In another embodiment, the antenna may be arranged at the surface of the antenna structure side-by-side to the openings (opposed to the stack), for example the aperture and/or the slot. The antenna may be configured e.g. as a patch antenna, a slot antenna, or a horn antenna.

In an embodiment, the channel defines a waveguide. In an embodiment, the channel defines an antenna wave emitter or wave receiver. The antenna can be configured as a slot antenna or as a patch antenna. Thus, the channel may yield an efficient, compact, and reliable waveguide application.

In an embodiment, the waveguide is in direct physical and/or electromagnetic connection with the antenna. This may provide the advantage that the functionality and/or the design flexibility is highly improved. The (embedded or surface-mounted) antenna may be used to emit/receive the electromagnetic waves into/from said waveguide through a direct (physical) or indirect (electromagnetic connection).

In an embodiment, a portion of the opening/channel of the antenna structure is configured as the waveguide and a further portion of the opening/channel is configured as the antenna wave emitter or wave receiver. In an example, the channel may comprise a specific shape with different portions, which are configured for different tasks. In another example, a plurality of openings may be provided and dedicated to different tasks, e.g. emitting, transmitting, and receiving. Thereby, efficiency and reliability may be improved.

In an embodiment, the antenna assembly further comprises a metal structure, wherein said metal structure comprises at least one of the following featu res:
i) a first metal layer structure comprising a first recess exposed to one first surface and defining a first external boundary profile;
ii) a second metal layer structure comprising a second recess exposed to a second surface and defining a second external boundary profile;
iii) the first metal layer structure and the second metal layer structure are stacked to face each other, so that the first recess and the second recess define a common recess.

In an embodiment, the opening and/or the channel is at least partially formed by the common recess of the metal structure. This may provide the advantage that a highly efficient metallization of the channel is provided in a cost-effective manner.

In an embodiment, the first external boundary profile of the first recess and the second external boundary profile of the second recess are misaligned in the stacking direction of the metal structure. This structural feature may reflect an innovative manufacturing using etching.

In the present context, the term "metal structure" may in particular refer to a (layer) structure that comprises metal and is suitable to form one or more recesses therein by material removal, preferably by (wet chemical) etching (leading to structural features in the metal structure). Alternatively, other material removal processes may be applied, for example laser erosion and/or plasma etching. To form such a metal structure, a metal layer such as a copper foil may be used as a starting material. The recesses may be formed as blind holes and/or through holes and/or as trenches. For example, an etching process may be applied to remove metal material, leaving behind metal material structures (e.g. pillars or walls) with the recesses in between, respectively. Arranging two or more of such metal structures, may interconnect two or more recesses, thereby forming at least one common recess.

Preferably, the common recess may comprise an elongated shape, for example like a (closed) tube, wherein at least one extension of the common recess, for example the length, may be at least five times, in particular at least 10 times, longer than at least another extension, for example the width or hight. In an embodiment, the metal structure may be embedded in a component carrier and/or antenna structure. In another embodiment, the metal structure may be surface-mounted to a component carrier and/or antenna structure. The metal structure may be in particular configured for an RF front-end (antenna/radar) functionality. For example, the common recces may be configured as an opening (preferably to a channel), thereby providing a waveguide for an electromagnetic wave signal. Two or more recesses of a metal structure may have the same depth or different depths. Preferably, the respective depths of the recesses in the metal structure are well defined. This may be achieved by the above-mentioned etching process.

In the present context, the term "misalignment" may refer to a structural feature (defect) that reflects a process step of etching. A result of the misalignment may be small edges/steps, or a suddenly disrupted surface/interface between the metal structure and the channel. In an example, the "misalignment" may be +/- 10 µm or lower, dependent on the thickness of the metal structure/foil, etching depth, and final application.

In the present context, the term "external boundary profile" may in particular refer to the shape of a recess in a metal (layer) structure. The profile may hereby be defined by a sidewall portion and/or an edge portion and/or a wall/pillar between two neighboring recesses.

According to an exemplary embodiment, idea an RF front-end (e.g. antenna or radar) application can be provided in an efficient and reliable manner, when a first recess is formed in a first metal layer structure by a first etching, a second recess is formed in a second metal layer structure by a second etching, and wherein the metal layer structures are stacked (attached to each other), so that the first recess and the second recess together form a common recess. Said common recess may then be used for different applications, such as for an efficient and reliable RF front-end application, for example a wave guide channel or for a fluid flowing inside said recess.

Using an etching process, the dimensions (e.g. depth, shape, width, etc.) of the recesses may be controlled in a reliable manner (especially when surface active additives are used to propagate). The etching process may be done in a single step (e.g. etching done from top and bottom simultaneously). A large variety of recesses (e.g. blind recesses, through recesses, etc.) are possible, thereby enabling a high design flexibility. The starting material for such an etching process may be for example a copper foil (alternatively, other metals, e.g. nickel, chromium, tin, silver, etc. may be used), i.e. a common and unexpensive raw material from the component carrier manufacture. The etching process may be seen in the final (metal structure, component carrier) product for example by structural features such as a misalignment between the first and second recess, when the common recess has been formed.

Conventionally, wave guides are formed by metallizing a channel in electrically insulating material. According to the described disclosure, however, the wave guide channel itself may be formed in metal material in an efficient and highly accurate manner.

The present disclosure may provide many advantages. For example, the metal structure may be highly robust and thus provide stability to itself and/or a component carrier. The metal structure may be used as a design-flexible inlay that may be assembled (e.g. embedded in or mounted on a further structure such as a component carrier and/or antenna structure). The inlay may be manufactured separately from the component carrier. The metal structure may function as an efficient electromagnetic shielding structure. Further, the metal structure may be provided with a very thin height (in the z-direction), thus enabling efficient packing. The height of the metal foil may be dependent from the recess height, while the recess height may be dependent on the frequency (especially the joint recess should be in line with the wavelength). Additionally, the metal structure may be at least partially used for thermal management (e.g. cooling, heat transfer, etc.).

Furthermore, the formation of the recesses on the metal structures through the known subtractive processes (such as etching, laser erosion) on two faced metal layer structures, resulting in the misalignment of the respective externally boundary profiles of the recesses, may result in a cheap and easy way to manufacture the metal structure with (internal) recesses.
In an embodiment, the common recess has an irregular profile, in particular along the stacking direction (e.g. the vertical direction Z). For example, the sidewalls of the common recess may be formed at least partially irregular. In a further example, the first recess and the second recess comprise at least partially different profiles. This structural feature may reflect the advantageous manufacture process by etching or eventually laser, which may result in (partially) irregular profiles. In this document, the term "irregular profile" may denote a non-planar lateral surface of the common recess having a plurality of indentations and/or protrusions. Additionally or alternatively, the irregular profile may have round shaped and/or sharp corners and/or edges pointing inwardly and/or outwardly.

In an embodiment, the common recess has at least one rounded portion (see e.g. Figures 2, 3). Depending on the desired application, an irregular and/or rounded portion may be preferable, depending on the subtractive process that better fits in the manufacturing of the metal structure. A round portion may reflect the advantageous manufacture process by etching which may rather lead to a round than a different shape (in particular at the bottom of the respective recess).

In an embodiment, the first recess and/or the second recess comprises the rounded portion. In other words, the rounded portion may be obtained to one of the recesses or both. For example, the first recess may be formed by another process as the second recess. In this example, one recess may comprise a rounded portion, while the other recess may not comprise a rounded portion. Depending on the desired application, a high design flexibility can be provided.

In an embodiment, the width of the (first/second) recesses between the two (first/second) boundary profiles are smaller (or equal or larger) than the width of an intermediate portion of the common recess (in particular when viewed along the stacking direction). In other words, the intermediate portion of the common recess may be larger (comprises a larger width/diameter) than the sidewalls/bottom of the first recess and/or the second recess. This structural feature may reflect the advantageous manufacture by etching, e.g. producing rounded or broader portions deeper in the respective metal layer structure, and generating narrower portions around the surface of the metal layer structure.

In an embodiment, metal material structures (in particular walls between planarly adjacent recesses) may comprise a smaller (or equal or larger) width (in the horizontal direction) than the (common) recesses defined between the metal material structures. The distance (recess) between walls/pillars and their height may be dependent on the wavelength. The metal material structure may act as a shielding structure to hinder electromagnetic waves from escaping, thereby reducing losses.

In an embodiment, the first external boundary profile and/or the second external boundary profile define(s) an undercut (structure) of the metal structure (in particular along the stacking direction). Such an undercut may be formed for example at an interface between a bottom portion and a sidewall portion of a recess. Further, such an undercut may be formed at an interface between the sidewall portion of a recess and the (main) surface of the respective metal layer structure (in other words: the edge of the recess) (see e.g. Figure 2). The term "undercut" may in particular refer to the circumstance that, in the stacking direction and along the profile of the recess, a small cut-out/indentation is present. The undercut may be a typical relict from an etching process, which may be especially advantageous to form the recesses in the metal layer structure.

In an embodiment, the first external boundary profile and/or the second external boundary profile has a convex/concave extension along the thickness (direction, e.g. ZX or ZY). In an embodiment, the first external boundary profile and/or the second external boundary profile is rounded and/or slanted externally. In an embodiment, the convex/concave shape may mechanically stabilize the metal structure. Additionally, the convex/concave shape may reduce the RF signal propagation losses.

In an embodiment, the common recess has an irregular profile, in particular along the planar direction (horizontal plane) and/or the stacking direction. Depending on the manufacture process (and/or the desired application), the profile of the common recess may comprise irregular structures that may be produced during the described advantageous etching process.

In an embodiment, the first recess and/or the second recess extends along a linear direction (L), wherein the deviation (along the linear extension) of the first external boundary profile and/or the second external boundary profile of the respective recess or the deviation (along the linear extension) between the distance of the respective first external boundary profile and the second external boundary profile is 100 µm or lower, in particular 50 µm or lower, in particular in the range 5 to 100 µm, more in particular in a range 5 to 50 µm. The described circumstance may be related to the impreciseness of a single boundary line (e.g. not following (perfectly) the above described linear extension, due to the intrinsic impreciseness of the erosion, in particular etching erosion). Additionally or alternatively, the described circumstance may be related to two boundary lines belonging to the same metal layer structure. Said boundary lines may refer to the surfaces of the metal material structures (pillars, walls) that define a recess in between.

In an embodiment, the first recess and the second recess face each other, so that they define the common recess as a mirror half shape. In other words, the first recess may be a mirror image of the second recess (and the other way around). Thus, both recesses may have (essentially) the same shape. In an example, both recesses may comprise a rounded portion, so that the resulting common recess would comprise a rounded (e.g. circular) shape. In another example, both recesses comprise an irregular shape, so that the resulting common recess would comprise an irregular shape. Thereby, a highly symmetrical common recess may be provided, which may be advantageous e.g. for an application of the common recess as a waveguide. Moreover, said mirror half shape can be the footprint of the usage of the same process to form the recesses on both metal layer structures, thereby streamlining the manufacturing process in a cheap way.

In an embodiment, the misalignment along the stacking direction of the metal structure comprises an edge, in particular a sharp edge, structure, exposed inside the common recess. For example, a part of the metal material structure (that separates neighboring recesses from each other), may extend into the common recess. Said part may be in particular the edge structure of the recess. The sharp edge may interact with RF signals when applied to the common recess and thus may ensure reliable signal propagation having low, in particular no, signal losses.

In an embodiment, the edge extends at least partially along the planar extension (horizontal plane X, Y). In an embodiment, the edge corresponds to only one portion of the first external boundary profile and/or the second external boundary profile (in particular belongs to metal material structure). Such a misalignment may be due to the fact that both recesses do have not exactly the same shape. Such a defect may be typical for an etching step used to from the recesses.

In an embodiment, the metal structure further comprises a further first recess in the first metal layer structure and/or a further second recess in the second metal layer structure. The first metal layer structure may comprise a plurality of first recesses and/or the second metal layer structure may comprise a plurality of second recesses. Hereby, the first recesses may be (essentially) identical and/or the second recesses may be (essentially) identical. Alternatively, the first recesses have a deviation from the second recesses in width and/or length and/or depth smaller than 50 µm, in particular smaller than 25 µm, and/or 10% relative to each other.

The term "further recess" may refer in this context to a further first/second recess that is different from the first/second recess, for example in shape, size, depth, width, etc. Alternatively, the term "further recess" may refer in this context to a further first/second recess that is equal/different to the first/second recess, for example in shape, size, depth, width, etc., in particular different only by the tolerances resulting from the used manufacturing method. Providing different recesses (and accordingly different common recesses) may enable a high design flexibility and/or combination of different applications within one device.

In an embodiment, the first recess and the further first recess at least partially have a common planar extension, in particular are parallel. In an embodiment, the second recess and the further second recess at least partially have a common planar extension, in particular are parallel. In an embodiment, the first recess and the further first recess have at least partially a common vertical extension, in particular are parallel. In an embodiment, the second recess and the further second recess at least partially have a common vertical extension, in particular are parallel. Thereby, the manufacture may be straightforward, and the reliability may be increased. Additionally and/or alternatively, parallel horizontally and/or vertically aligned recesses may enable creating a common recess in a precise manner.

In an embodiment, the first recess and the further first recess have a different or comparable/similar shape/size. In an embodiment, the second recess and the further second recess have a different or comparable/similar shape/size. Preferably, the difference(s) in terms of dimensions and/or shapes are affected and/or are directly derivable, by the tolerances reachable by the used manufacturing method to form said recesses. This may increase the flexibility of forming recesses having defined shapes using the described method.

In an embodiment, the common recess defines a fluid-tight channel. Thus, a fluid may be accommodated in the common recess in a reliable manner for different advantageous applications. Preferably, tightness of the channel is imparted by a suitable adhesive element between the first metal structure and the second metal structure, at least at the periphery first and the second external boundary profiles.

Additionally or alternatively, the tightness of the channel is imparted by the bonding and / or the welding of the first metal structure with the second metal structure, at least at the periphery first and the second external boundary profiles. In an example, the fluid may be gaseous, in particular air. In this configuration, the channel may be used as an (air filled) waveguide. In a further example, the fluid may be gaseous/liquid and may be used for a cooling/heat transfer purpose. In an embodiment, at least one common recess (channel) may be used for an RF functionality (e.g. antenna waveguide), while at least one further recess (channel) (of the same metal structure) may be used for a non-RF functionality (e.g. as a cooling structure). This may bring the advantage, that the common recess may be used for various reasons and/or applications, e.g. thermal management and/or electromagnetic wave transmission.

In an embodiment, a common recess may be configured for heat transmission, whereas another common recess may be configured for electromagnetic wave transmission (both being located in the same metal structure). This may increase the functionality of the metal structure and/or save space inside the component carrier since two functions may be provided within one constituent.

In an embodiment, the first metal layer structure and the second metal layer structure are directly connected one to each other (with or without a bonding material in between). This may provide the advantage that a thin metal structure can be formed without further intermediate connection structures/layers). The metal layer structures may be connected/attached to each other by established technologies in the component carrier manufacture, for example diffusion bonding, welding, nano-wires, sinter paste, solder, resin sheets, thermal interface materials, etc. In an embodiment, the connection may be realized with a thin low Dk/Df resin sheet. For thermal connection of the layers, sinter-pastes or thermal prepregs may be preferable.

In an embodiment, the first metal layer structure and the second metal layer structure are connected by a bonding material. Such a metal structure may be considered as directly connected. Examples for bonding materials may include a solder material, a sinter material, nanowires, a glue, a welding material. Thus, established and reliable techniques may be directly applied to provide a robust and thin metal structure.

In an embodiment, the first metal layer structure and the second metal layer structure are indirectly connected one to each other by at least one intermediate layer, in particular an electrically insulating layer (structure). Such an intermediate layer may add stability and/or additional functionality, thereby increasing the design flexibility.

In an embodiment, the at least one intermediate layer is sandwiched between the first metal layer structure and the second metal layer structure. In an embodiment, the at least one intermediate layer comprises an electrically conductive layer structure and/or an electrically insulating layer structure.

In an embodiment, the at least one intermediate layer defines a strip (and/or transmission line; optical coupling structures) inside the common recess. In an embodiment, the at least one intermediate layer is at least partially configured as an antenna. This may provide the advantage that the intermediate layer may at the one hand interconnect the metal layer structures efficient, and at the other hand add a further functionality. For example, the intermediate layer (structure) may serve as at least part of an antenna to emit/receive an RF signal in/from the common recess. In other words, the intermediate layer may be used as an emitter/receiver (transmission/emission or receiver structure) for the RF signal transmitted through the common recess channel/waveguide. In an example, the intermediate layer is configured as a copper trace that provides/receives RF signals.

In an embodiment, the metal structure further comprises: a component, arranged on the at least one intermediate layer (in the common recess). In a specific embodiment, the intermediate layer (with the component) is configured as a suspended antenna strip-line. The component may be for example an RF component, in particular a HF (high frequency) component, configured to trigger an RF functionality in/into the common recess. Component embedding may hence be done in a straightforward and easy manner. For example, the component is arranged at the intermediate layer and placed between the metal layer structures. In another example, the component is arranged at the intermediate layer, when coupled to one of the metal layer structures, and before adding the other metal layer structure.

In an embodiment, the intermediate layer comprises an electrically insulating layer structure, wherein conductive interconnections extend through said electrically insulating layer structure, and wherein the conductive interconnections connect the first metal layer structure and the second metal layer structure (thermally and/or electrically). This may provide the advantage that an interconnection between the metal layer structures (through the intermediate layer) can be provided in a cost-effective manner. The interconnection may be used to transfer electric current and or heat between the metal layer structures, e.g. to a heat sink. In an example, the conductive interconnections may have a shape or a conductive via, or having straight sidewalls, for example a cylinder, or may have a shape having tapered sidewalls, for example a cone. In a further example, the conductive interconnection(s) may comprise metal, in particular metal, and/or may comprise a paste.

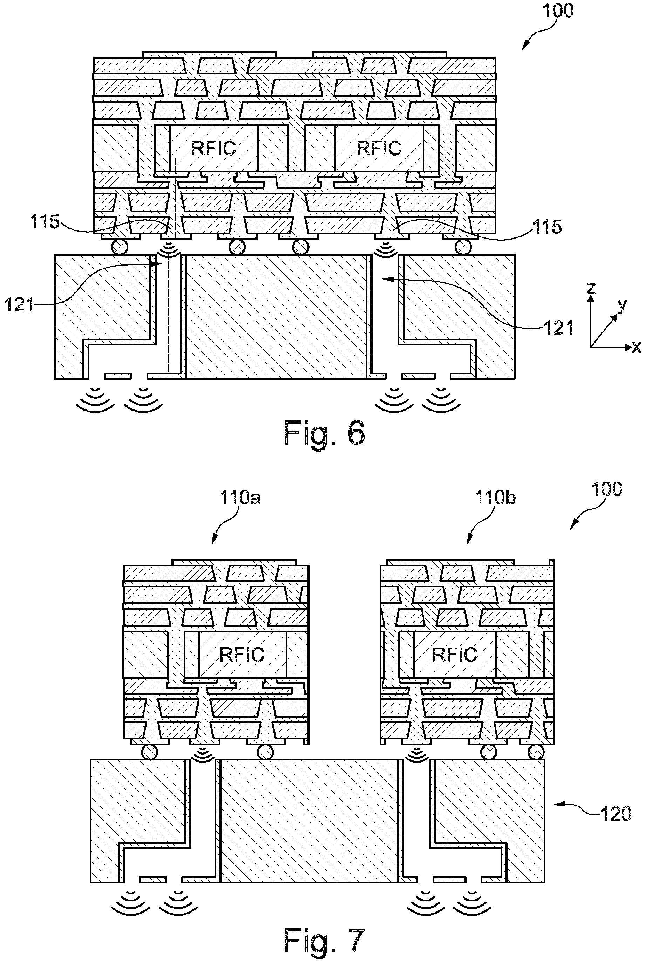

In an embodiment, at least one first metal layer structure and/or at least one second metal layer structure comprises a blind recess (blind hole) or a through recess (through hole). As can be seen e.g. in Figure 1, a metal layer structure can comprise blind recesses and/or through recesses. Through recesses may provide specific advantages, e.g. an RF functionality outside of a common recess channel. As is shown in Figure 6 for example, a blind hole and a through hole can be connected, thereby providing a common recess with an opening (e.g. a slot) to the outside/environment of the metal structure. Such an opening can be applied e.g. for a slot antenna.

In an embodiment, the through recess extends along one direction along the stacking direction, in particular along a straight direction (see e.g. Figure 1). In an embodiment, the through recess extends along two different directions along the stacking direction. A through hole may be formed in different ways, for example by etching completely through the metal layer structure. Yet, in another embodiment, a through hole may be formed by etching in a first step a first main surface of the metal layer structure and by etching in a second step a second main surface (preferably opposed to the first main surface) of the metal layer structure. In other words, material is removed from both (opposing) sides of the metal layer structure. In an embodiment, one material removal step is done by etching, while the other material removal step is done by the same method (etching) or another method, e.g. one of plasma etching, drilling, routing, etc.

When forming a through recess from both sides of the metal layer structure, the two (or more) portions may have different dimensions (e.g. shape, size, etc.). In particular one portions may be larger/deeper than the other portion (see e.g. Figure 3) (i.e. asymmetric).

In an embodiment, the through recess comprises an hour-glass (like) shape. In an embodiment, the through recess comprises an asymmetric shape. This may provide the advantage that an efficient material removal from both sides may be done by etching. An asymmetry may be advantageous for specific applications. Such an asymmetric structure may comprise two etched portions on top of each other with a protrusion (e.g. a sharp edge) in between.

In an embodiment, the common recess (is configured to) encloses a fluid, for example gaseous (in particular air), or liquid (in particular a heating exchanging medium). A fluid-filled recess may be efficiently be used as a channel, e.g. an air-filled waveguide. In a further embodiment, a least one (common) recess may be filled by a (heat exchange) liquid to transfer heat, thereby preventing overheating.

In an embodiment, the common recess encloses (is at least partially filled by) a solid filler material, in particular a low DK material. Thereby, an RF (antenna) functionality may be enhanced.

In an embodiment, the first metal layer structure and the second metal layer structure have a different thickness one to each one, in particular a difference of 50 µm or more. Such an asymmetric structure may have different advantageous applications, e.g. one thick layer may be sufficient for stabilization, so that material of the other layer can be saved. Alternatively, the first metal layer structure and the second metal layer structure can have the same thickness.

In an embodiment, the metal layer structure has a thickness larger than 30 µm, in particular larger than 50 µm, in particular larger than 300 µm. Hence, a thin metal structure may be provided that can be applied to component carriers and/or antenna structures in an easy, cost-efficient, and space saving (thus flexible) manner. For thin foils, a carrier may be used for the etching process.

In an embodiment, the (first/second) metal layer structure may comprise a surface finish, for example gold or ENIG/ENEPIG.

Furthermore, the surface finish may be an inorganic material, e.g. a glass structure (or a ceramic material). The surface finish may comprise at least one glass barrier layer. The at least one glass barrier layer may comprise two main surfaces, wherein the two main surfaces comprise a different adhesion property (for example a different surface tension (property)) (with respect to each other).

In an embodiment, the two main surfaces of the at least one glass barrier layer comprises hydrophilic properties, and/or the other one of the two main surfaces of the at least one glass barrier layer comprises hydrophilic properties or hydrophobic properties.

In the context of the present document, the term "glass barrier layer" may in particular refer to a layer (structure) that comprises glass material and is, at the same time, suitable to fulfill a barrier function, in particular regarding the migration of chemical species. In this context, the term "glass" may in particular refer to a non-crystalline and amorphous solid. In a preferred example, the glass comprises silicate, in particular silicon dioxide (SiO₂). In a further example, the glass comprises at least one silane and/or siloxane compound. In yet another example, the glass may comprise functional groups, e.g. hydrophilic and/or hydrophobic functional groups, in particular at the main surfaces. Since the glass barrier layer is a (continuous or discontinuous) layer, it comprises two main surfaces opposite to each other. Hereby, the two main surfaces can be different in at least one physical/chemical property, specifically regarding their surface tension (surface energy).

Further, high frequency signal application and/or fine line applications may be significantly improved by the described approach, in particular because smooth metal surfaces can be applied. Additionally, adhesion promoting processes, e.g. bond-film process for inner layers, may be replaced as well as micro-etching processes for outer layers.

In an embodiment, etching (or laser erosion) is done from top and bottom (simultaneously). In an embodiment, the velocity of the foil, while passing through the etching apparatus, is adjusted to the recess depth (quickly going through the etching apparatus means less depth). In an embodiment, a photoresist determines etching compensation. In an embodiment, the process chemistry (specially additives) determine under-etch (structural feature).

In a specific embodiment, the disclosure may refer to at least one of the following aspects: i) etching of bare copper foils yielding copper pillars/walls with different but controlled depth profile, ii) through holes can be obtained, iii) using copper structures solely without prepreg allows for manufacturing of fully shielded structures capable of transmitting RF signals (not DC applied), iv) miniaturized 3D waveguide antennas can be obtained with decreased z-height, v) antenna can be used for thermal management (waveguides are less sensitive to temperature changes), vi) for RF front end antennas limited to (waveguide) antennas, the disclosure can be used for cooling purposes as well.

In an embodiment, the stack is coupled (interconnected) with (the upper main surface of) the metal structure through an intermediate layer structure. The intermediate layer structure can be an electrically insulating structure, for example low flow prepreg and/or low Dk/Df material. Between exposed electric connections of the stack and the metal structure, there may be arranged solder balls (BGA) and/or further interconnection structures, for example sinter paste (may be any metal paste), conductive paste, nanowires, or a thermal prepreg. The connection structures through the intermediate layer structure can be (partially) applied for the RF signal and/or (partially) (or fully) applied as cooling channels. In this embodiment, the metal structure may be used as a heatsink (in addition to the RF signal functionality; thermal path and signal path). In an embodiment, the intermediate layer structure is realized without (inter) connection structures, but for example as a conductive paste or nanowires.

In an embodiment, the electromagnetic wave coupling structure comprises a launcher structure configured for transmitting electromagnetic waves from the stack to the antenna structure (and/or the other way around). Specifically, electromagnetic waves are transmitted from the launcher (in) to the channel. As described above, a launcher may be seen as an element suitable to feed electromagnetic waves (RF signals) into an opening/channel, in particular a waveguide. The electromagnetic wave coupling structure (preferably formed as an electrically conductive layer structure during stack manufacture) may be configured as such a launcher, essentially without further costs/efforts.

In an embodiment, the launcher comprises a conductive layer structure. In an embodiment, the conductive layer structure is provided on/in a second electrically insulating layer structure of the stack, wherein the second electrically insulating layer structure comprises a material and/or a constituent different from that of the at least one electrically insulating layer structure. In an embodiment, the second electrically insulating layer structure comprises a high frequency material (for example Meg8, Isola, ABF GL), in particular a low Dk/Df material. In an embodiment, the second electrically insulating layer structure is free from a covering structure, in particular free from a surface finish and/or solder resist.

This may provide the advantage that the electromagnetic wave coupling structure/launcher/conductive layer structure is coupled to/arranged on/arranged in an electrically insulating layer structure that comprises a specific material suitable for RF/HF applications. Hence, the signal transmission quality/performance may be highly increased. For example, a material with a low Dk/Df may be applied.

In an embodiment, the launcher planar extension (in the horizontal plane) (or the width/diameter) is smaller (or equal or larger) than the planar extension of the opening/channel (in particular the waveguide) of the antenna structure. This may provide the advantage that the RF signals can be fed into the channel/waveguide in a highly accurate manner.

In an embodiment, the launcher is directly facing the waveguide (without a further structure/element in between). This may enable most efficient signal transmission.

In an embodiment, the size auf the launcher is larger than the size of a pad of the electrically conductive layer structure. Thereby, leakage may be suppressed. For example, the minimum required pad length/distance may be smaller than 450 µm for 77 GHz. In an example, the distance to suppress the leakage wave may be calculated as a function of dielectric material Dk filling the pad and frequency.

In an embodiment, the central point/portion/part of the launcher is misaligned with the central point(portion/part of the respective (air) channel. With the described approach, such a misalignment may be efficiently compensated. For a typical patch antenna-like structure used for a launcher, the misalignment tolerance may be relaxed as the patch dimension is quite large. In a specific example, the patch size in an IC-substrate would be around 1.0 x 1.5 mm and 10% of misalignment may be acceptable, then up to 100 µm in x-axis and 150 µm in y-axis misalignment would be a reasonable value.

In an embodiment, the launcher comprises at least a portion of the at least one electrically conductive layer structure (see above).

In an embodiment, the (air) channel (vertical waveguide) may be typically either rectangular or elliptical. Depending on that, the launcher could be modified as well due to the electrical/magnetic field polarization (mode-matching). A typical design for a launcher may be: rectangular patch, slot, dipole, monopole (basically typical structures used for PCB antennas).

In an embodiment, the launcher comprises an external protection structure, in particular a surface finish (for example ENIG or ENEPIG). In an example, the external protection structure is Nickel-free, thereby eventually increasing the performance. As described above, the launcher may be formed by a conductive layer structure, e.g. an electrically conductive layer structure of the layer stack. Yet, the launcher may also be formed by a (electrically conductive) surface finish. Also in this embodiment, the formation of the launcher may be directly integrated in the stack manufacture, (essentially) without additional costs/efforts.

In an embodiment, the electromagnetic waves coupling structure is connected with the embedded component only with the electrically conductive layer structures of the stack. In an embodiment, said electrically conductive layer structures are solder material-free. In an embodiment, the connection is composed of vias and traces/pads only. In a preferred embodiment, said electric connection between embedded component and electromagnetic waves coupling structure is realized by a redistribution layer (structure). Such a RDL may be common in the field of layer build-ups and may serve to translate small contacts of the component to large contacts at the surface (e.g. solder balls). Accordingly, the component may be efficiently connected (without additional effort) to surface electric contacts and/or the electromagnetic waves coupling structure.

In an embodiment, the electromagnetic wave coupling structure comprises an external layer structure of a material not affecting the electromagnetic waves, in particular a hydrophobic material. Thereby, an efficient protection (e.g. against copper migration) may be provided without affecting the signal transmission quality.

Said external layer structure may be configured as a hydrophobic protection film. In the context of the present document, the term "hydrophobic protection film" (or hydrophobic protection layer or hydrophobic protection ink or hydrophobic protection coating) may particularly denote a thin layer (film-like layer structure) of material that comprises hydrophobic properties. In an embodiment, a hydrophobic protection film may be provided onto a surface of an electrically conductive layer structure and/or an electrically insulating layer structure, hereby serving as a protection layer. For example, a metal layer may be protected from corrosion using the hydrophobic protection film, since water and other fluids/liquids may be kept away due the hydrophobic properties. In another example, an electrically insulating material, for example an (organic) polymer, may be protected from decomposition (e.g. dissolution or swelling) using the hydrophobic protection film, since water and/or polar organic solvents may be kept away due to the hydrophobic properties. In another embodiment, the hydrophobic protection film may cover an opening, for example an access hole to the cavity. Thereby, the inside of the cavity may be protected against fluid (in particular liquid) from the outside. Yet, the hydrophobic protection film may be permeable for gas and/or electromagnetic waves and/or sonic waves, thereby enabling at the same time a protection function and a technical application function. In a further embodiment, the hydrophobic protection film may be formed inside of an opening, e.g. fill said opening as a hydrophobic protection (filling) material. Yet, the hydrophobic protection film may be electrically insulating.

The hydrophobic protection film may comprise organic material and/or inorganic (layer structure) material (e.g. glass).

In one example, a mixture of components such as a toughening resin, a flexibilizing hardener, a basic hardener, a defoamer, a functional filler, and a crosslinking agent may be used (polymer, organic hydrophobic protection film).

In another example, the hydrophobic protection film may comprise an inorganic material, e.g. glass (in particular silicon dioxide). In an example, the hydrophobic protection film may comprise two main surfaces, wherein the two main surfaces comprise a different adhesion property (e.g. hydrophobic and hydrophilic).

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular soda lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above mentioned example, such as: MoS₂, CuGaOz, AgAlO₂, LiGaTe₂, AgInSe₂, CuFeS₂, BeO.

In this context, the term "glass" may in particular refer to a non-crystalline and amorphous solid. In a preferred example, the glass comprises silicate, in particular silicon dioxide (SiO₂). In a further example, the glass comprises at least one silane and/or siloxane compound. In yet another example, the glass may comprise functional groups, e.g. hydrophilic and/or hydrophobic functional groups, in particular at the main surfaces. Since the glass layer is a (continuous or discontinuous) layer, it comprises two main surfaces opposite to each other. Hereby, the two main surfaces can be different in at least one physical/chemical property, specifically regarding their surface tension (surface energy).

In an embodiment, the electromagnetic wave coupling structure is provided at the external main surface of the stack. In an embodiment, the electromagnetic wave coupling structure is provided in a recess, in particular in an opening at the external main surface of the stack. Depending on the desired application, one of these options may be preferable. While a recess may provide additional protection, an external main surface may lead to better signal transmission.

In an embodiment, the launcher structure can be arranged at the bottom of a cavity, in particular wherein the cavity walls are shieled (e.g. a 2.5D^{™} cavity). This may additionally (physically) protect the launcher structure.

In an embodiment, the stack is directly connected with the antenna structure. In an embodiment, connected by at least one of an adhesive, a solder material, a through solder structure, a connecting element, in particular a nanowire or a pillar, or a sinter structure. Thus, both structures can be (electrically) interconnected in a robust manner using established and reliable measures.

In an embodiment, sinter paste and/or conductive paste (e.g. z-interconnection paste (Ormet paste)) may be applied (see e.g. Figure 19). This may provide the advantages that a conductive paste can be used as shielding structure surrounding the launcher structures. In addition, the distance between antenna and launcher may be further reduced, thereby limiting signal losses.

In an embodiment, the stack is connected with the antenna structure at a (first) distance, in particular wherein said (vertical) distance between stack and antenna structure is smaller than 200 µm, in particular smaller than 100 µm. This short distance may enable a small/thin module size and/or a highly efficient feed of RF signals in the channel/waveguide.

In an embodiment, the stack and the antenna structure are connected by a connection structure, in particular solder balls (see e.g. Figure 1) (e.g. BGA), conductive paste, sinter connection, nanowires, or an electrically insulating connection (glueing, laminating, etc.). Said connection structure may require more space than only interconnecting the stack and the antenna structure. Yet, the connection structure may render the connection more robust/reliable.

In an embodiment, the antenna structure has a planar extension (in the horizontal direction) greater/larger (or equal or smaller) than that of the stack. This implies that the stack is provided in an especially small and compact design. Further, the antenna structure extension may be larger to provide additional openings/channels, thereby enabling a wider range (e.g. for radar applications).

In an embodiment, the component is fully embedded in the stack. Thereby, optimal protection may be provided.

In an embodiment, the component is located in a vertical (direction) central portion. In an embodiment, the component is embedded in a (central) core layer structure. Such a core layer structure may be thicker than other layers of the stack and/or comprise a specifically robust material such as e.g. fully cured resin (e.g. FR4), metal, glass, or ceramic. Embedding in the core may be efficient and robust (in particular during manufacture). Further, embedding of two or more components (side-by-side) may be preferably realized in a core layer structure.

In an embodiment, a respective build-up layer is located on both opposed main surfaces of the component. In other words, there may be arranged an upper layer build-up on top of the component (and/or the core layer structure) and/or there may be arranged a lower layer build-up at the bottom of the component (and/or the core layer structure). Such a build-up may enable efficient embedding and additional functionalities such as electrical connections to the main surfaces.

In an embodiment, the component comprises electrical connections on both opposed surfaces. Hence, the component may be connected to both main surfaces and/or interconnect said two main surfaces. This may enable further functionalities by connecting the component to further devices.

In an embodiment, a heatsink can be applied on top of the stack, in particular connected to the embedded component. Thereby, thermal management may be improved. In an embodiment, thermal vias/inlays can be used to (further) remove the heat. Further, a signal path may be decoupled from a thermal path.

In an embodiment, a plurality of stacks is connected to one common antenna structure. This embodiment may be advantageous for specific applications (e.g. radar). Two or more stacks (e.g. side-by side, with or without physical contact) may be arranged to a common antenna structure. In this manner, a high number of channels may be established in an easy, flexible, and straightforward manner. A further advantage may be that, if just a single module is broken, it can be exchanged without throwing away the rest of the expensive components.

In an embodiment, the surface of the stack opposite to the surface connected with the antenna structure comprises at least one connecting portion, said at least one connecting portion being configured to be connected to an external component and/or to a further stack. This may highly increase the design flexibility.

In an embodiment, there is described an antenna system, comprising:
i) a common further stack, and ii) one or more antenna assembly/assemblies as described above, mounted on the common further stack. In order to increase the robustness, a plurality of antenna assemblies may be arranged on a common mounting structure, preferably configured as a stack. Thereby, same materials/processes may be applied for the manufacture, thereby saving costs/efforts.

In an embodiment, at least two of the antenna assemblies comprise different features, in particular regarding frequency. Different antenna assemblies on a common further stack may enable a large variety of functionalities, thereby highly increasing the flexibility of applications.

In the context of the present application, the term "antenna" may particularly denote an arrangement of metallic conductor elements electrically connected for instance through a transmission line to a receiver or transmitter. Hence, an antenna may be denoted as an electrical member which converts electric power into radio waves, and/or *vice versa.* An antenna may be used with a controller (for instance a control chip) such as a radio transmitter and/or radio receiver. In transmission, a radio transmitter may supply an electric current oscillating at radio frequency (i.e. a high frequency alternating current) to the antenna 's terminals, and the antenna may radiate the energy from the current as electromagnetic waves (in particular radio waves). In a reception mode, an antenna may intercept some of the power of an electromagnetic wave in order to produce a tiny voltage at its terminals, that may be applied for example to a receiver to be amplified. In embodiments, the antenna may be configured as a receiver antenna, a transmitter antenna, or as a transceiver (i.e. transmitter and receiver) antenna. In an embodiment, the antenna may be used for a radar application. The antenna may, for example, comprise a dipole antenna, a folded dipole antenna, a ring antenna, a rectangular loop antenna, a patch antenna, or a coplanar antenna. The antenna may also comprise a yagi antenna or a fractal antenna. A yagi antenna may be a directional antenna for so-called mm wave applications. A fractal antenna may be another type of antenna that uses a self-similar design to maximize the length of a material in a total surface area. A fractal antenna may be compact and wideband and can act as an antenna for many different frequencies.

In the context of the present document, the term "radar" may refer to an object-detection that uses electromagnetic waves to determine the range, angle, or velocity of one or more objects. A radar arrangement may comprise a transmitter transmitting electromagnetic waves (e.g. in the radio or microwave range). The electromagnetic waves from the transmitter reflect off the object and return to a receiver. Hereby, one antenna may be used for transmitting and receiving. Furthermore, a processor such as an electronic component may be used to determine properties of the object such as location and speed based on the received electromagnetic waves.

In an embodiment, a distance (the air gap) between stack (package) and antenna structure (waveguide antenna) may be in the range 0 to 150 µm (smaller may be better).

In an embodiment, the launcher is configured as a slot or a patch.

In an embodiment, the opening comprises a circular, a rectangular or an elliptical shape.

In an embodiment, a distance between launcher and connection structure (solder ball) is smaller than 400 µm, in particular smaller than 300 µm.

In an embodiment connection structure (solder ball) is configured as a (electromagnetic) shielding structure for the launcher.

According to an embodiment, the stack is free from a cavity, which is filled with gas and/or a channel, in particular a wave guide. This may bring the advantage of using of the delimited volume of the stack more efficiently, since the cavity or channel may occupy a relatively large volume, for example 10%, of the stack. For this reason, the stack may comprise a high electrically conductive layer structure density, for example copper traces and/or vertically connection structures and the channel is located with another compartment of the antenna assembly, preferably in the antenna structure.

In an embodiment, a ground signal of the stack is electrically coupled with the antenna structure, in particular with a conductive coating of the channel. An electric connection between the stack and the antenna structure may be used only in case an electrical connection is needed (e.g. for grounding the sidewalls of the channel, connecting other components, etc.). Another option would be an electrically insulating connection by glueing, laminating, etc. (or both). Alternative electrical connections may be conductive paste, nano-wires, sintered connections, etc.

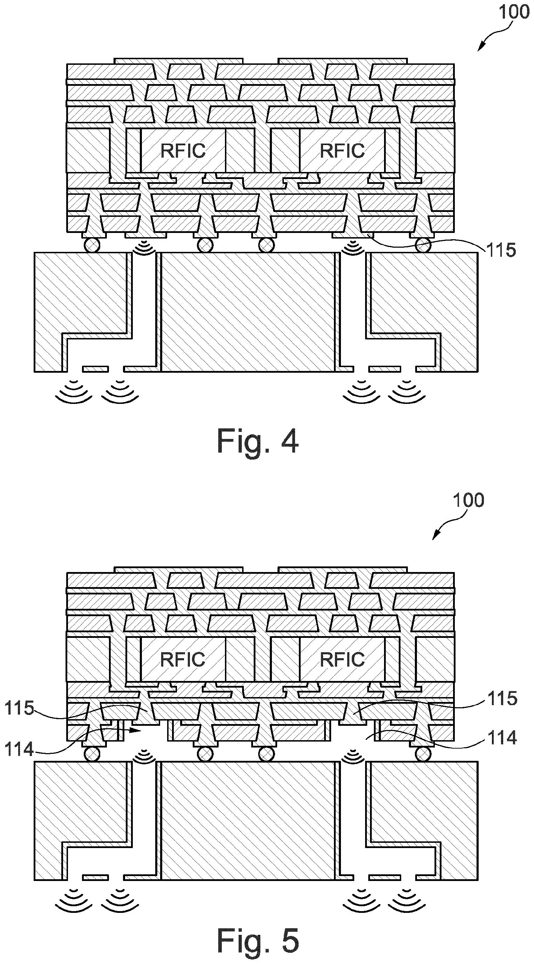

In an embodiment, the wave coupling structure (launcher) is located at least partially within a cavity of the stack (see e.g. Figure 5). This may provide the advantage that the RF/HF signal is guided/streamlined before entering the gap between stack and antenna structure (in particular the air channel).

In an embodiment, the antenna assembly comprises a surface-mounted component (e.g. a driver /processor) configured to drive one or more embedded components (e.g. RFICs). This configuration may be related to massive MIMOs (e.g. in imaging Radar and 5G/6G). In an example, the MMIC of a HR radar can be embedded, having the digital and analogue function combined in a single IC.

In an embodiment, the electromagnetic wave coupling structure is shifted/offset with respect to the corresponding channel opening (launcher/waveguide misalignment). The electromagnetic wave coupling structure and the corresponding channel opening still face each other, yet with a certain misalignment. Yet, the described antenna assembly may still allow for an efficient and reliable radio frequency functionality.

In an embodiment, the stack comprises at least one surface-mounted component, in particular at the main surface being opposite to the main surface that faces the antenna structure. Said surface-mounted component can be a further component and/or a heat-removing structure, e.g. a heatsink. In this manner, the stack may be divided in two functionalities: a thermal path (in the upper build-up towards the surface-mounted component), and a signal path (in the lower build-up towards the antenna structure).

In an embodiment, the (exposed) electrically conductive layer structure comprises a surface finish, e.g. the pads of said layer structure are covered by surface finish material. The surface finish comprises e.g. ENIG or ENEPIG. In an embodiment, the electromagnetic wave coupling structure is covered by said surface finish (as well). In an example, at least one launcher comprises a surface finish (being preferably Nickel-free, for example palladium or silver).

In an embodiment, the electromagnetic wave coupling structure is covered by a silicon-comprising protection layer (e.g. a selective SiOx protective coating) exposed on the outer surface. Thereby, efficient protection may be enabled that does not decrease the RF performance.

In an embodiment, the component carrier is shaped as a plate. This contributes to the compact design, wherein the component carrier nevertheless provides a large basis for mounting components thereon. Furthermore, in particular a bare die as example for an embedded electronic component, can be conveniently embedded, thanks to its small thickness, into a thin plate such as a printed circuit board.

In an embodiment, the component carrier is configured as one of the group consisting of a printed circuit board, a substrate (in particular an IC substrate), and an interposer.

In the context of the present application, the term "printed circuit board" (PCB) may particularly denote a plate-shaped component carrier which is formed by laminating several electrically conductive layer structures with several electrically insulating layer structures, for instance by applying pressure and/or by the supply of thermal energy. As preferred materials for PCB technology, the electrically conductive layer structures are made of copper, whereas the electrically insulating layer structures may comprise resin and/or glass fibers, so-called prepreg or FR4 material. The various electrically conductive layer structures may be connected to one another in a desired way by forming holes through the laminate, for instance by laser drilling or mechanical drilling, and by partially or fully filling them with electrically conductive material (in particular copper), thereby forming vias or any other through-hole connections. The filled hole either connects the whole stack, (through-hole connections extending through several layers or the entire stack), or the filled hole connects at least two electrically conductive layers, called via. Similarly, optical interconnections can be formed through individual layers of the stack in order to receive an electro-optical circuit board (EOCB). Apart from one or more components which may be embedded in a printed circuit board, a printed circuit board is usually configured for accommodating one or more components on one or both opposing surfaces of the plate-shaped printed circuit board. They may be connected to the respective main surface by soldering. A dielectric part of a PCB may be composed of resin with reinforcing fibers (such as glass fibers).

In the context of the present application, the term "substrate" may particularly denote a small component carrier, in particular an IC substrate. An IC substrate may be, in relation to a PCB, a comparably small component carrier onto which one or more components may be mounted and that may act as a connection medium between one or more chip(s) and a further PCB. For instance, an IC substrate may have substantially the same size as a component (in particular an electronic component) to be mounted thereon (for instance in case of a Chip Scale Package (CSP)). More specifically, an IC substrate can be understood as a carrier for electrical connections or electrical networks as well as component carrier comparable to a printed circuit board (PCB), however with a considerably higher density of laterally and/or vertically arranged connections. Lateral connections are for example conductive paths, whereas vertical connections may be for example drill holes. These lateral and/or vertical connections may in particular be arranged within the IC substrate and may be used to provide electrical, thermal and/or mechanical connections of housed components or unhoused components (such as bare dies), particularly of IC chips, with a printed circuit board or intermediate printed circuit board. A "substrate" in the context of the present application in particular facilitates electrical connections and/or dissipating heat and/or offering mechanical strength. Thus, the term "substrate" is in particular used as a synonym of "IC substrate" in the context of the present application. It has to be noted that the term "substrate" may in particular not been mixed up with the term "substrate" as it is usually used in the wafer context in which "substrate" usually means the substrate material used in wafer manufacturing as a base material upon which devices or circuits are built and which forms the foundational layer that supports the electronic or photonic structures integrated into a wafer. This is not what is meant with "substrate" in the context of the present application.

In the context of the present application, the term "inorganic layer structure" may particularly denote a layer structure which comprises inorganic material, such as an inorganic compound. In particular, dielectric material of the inorganic layer structure or even the entire inorganic layer structure may be made exclusively or at least substantially exclusively from inorganic material. In another embodiment, the inorganic layer structure may comprise inorganic dielectric material and additionally another dielectric material. An inorganic compound may be a chemical compound that lacks carbon-hydrogen bonds or a chemical compound that is not an organic compound. In an example, the inorganic layer structure may comprise glass, for example silicon base glass, in particular soda lime glass, and/or boro-silicate glass and/or alumo-silicate glass and/or lithium silicate glass and/or alkaline free glass. In another example, the inorganic layer structure may comprise ceramic material, for example aluminum nitride and/or aluminum oxide and/or silicon nitride and/or boron nitride and/or tungsten comprising ceramic material. Yet, in another example, the inorganic layer structure may comprise semi-conducting material, for example silicon and/or germanium and/or silicon oxide and/or germanium oxide and/or silicon carbide and/or gallium nitride. In a further embodiment, the inorganic layer structure may comprise (elemental) metal and/or metal alloys, for example, copper and/or tin and/or bronze. Yet in another embodiment, the inorganic layer structure may comprise inorganic material, which is not listed in the above mentioned example, such as: MoS2, CuGaO2, AgAlO2, LiGaTe2, AgInSe2, CuFeS2, BeO.

The substrate or interposer may comprise or consist of at least a layer of glass, silicon (Si) and/or a photoimageable or dry-etchable organic material like epoxy-based build-up material (such as epoxy-based build-up film) or polymer compounds (which may or may not include photo- and/or thermosensitive molecules) like polyimide or polybenzoxazole.

In an embodiment, the at least one electrically insulating layer structure (and/or the curable dielectric elements) comprises at least one of the group consisting of a resin or a polymer, such as epoxy resin, cyanate ester resin, benzocyclobutene resin, bismaleimide-triazine resin, polyphenylene derivate (e.g. based on polyphenylenether, PPE), polyimide (PI), polyamide (PA), liquid crystal polymer (LCP), polytetrafluoroethylene (PTFE), polyvinylidene fluoride (PVDF) and/or a combination thereof. Reinforcing structures such as webs, fibers, spheres or other kinds of filler particles, for example made of glass (multilayer glass) in order to form a composite, could be used as well. A semi-cured resin in combination with a reinforcing agent, e.g. fibers impregnated with the above-mentioned resins is called prepreg. These prepregs are often named after their properties e.g. FR4 or FR5, which describe their flame retardant properties. Although prepreg particularly FR4 are usually preferred for rigid PCBs, other materials, in particular epoxy-based build-up materials (such as build-up films) or photoimageable dielectric materials, may be used as well. For high frequency applications, high-frequency materials such as polytetrafluoroethylene, liquid crystal polymer and/or cyanate ester resins, may be preferred. Besides these polymers, low temperature cofired ceramics (LTCC) or other low, very low or ultra-low Dk materials may be applied in the component carrier as electrically insulating structures.

In an embodiment, the at least one electrically conductive layer structure comprises at least one of the group consisting of copper, aluminum, nickel, silver, gold, palladium, tungsten, carbon, platinum, (doped) silicon, and magnesium. Although copper is usually preferred, other materials or coated versions thereof are possible as well, in particular coated with supra-conductive material or conductive polymers, such as graphene or poly(3,4-ethylenedioxythiophene) (PEDOT), respectively.

At least one component may be embedded in the component carrier and/or may be surface mounted on the component carrier. Such a component can be selected from a group consisting of an electrically non-conductive inlay, an electrically conductive inlay (such as a metal inlay, preferably comprising copper or aluminum), a heat transfer unit (for example a heat pipe), a light guiding element (for example an optical waveguide or a light conductor connection), an electronic component, or combinations thereof. An inlay can be for instance a metal block, with or without an insulating material coating (IMS-inlay), which could be either embedded or surface mounted for the purpose of facilitating heat dissipation. Suitable materials are defined according to their thermal conductivity, which should be at least 2 W/mK. Such materials are often based, but not limited to metals, metal-oxides and/or ceramics as for instance copper, aluminium oxide (Al2O3) or aluminum nitride (AIN). In order to increase the heat exchange capacity, other geometries with increased surface area are frequently used as well. Furthermore, a component can be an active electronic component (having at least one p-n-junction implemented), a passive electronic component such as a resistor, an inductance, or capacitor, an electronic chip, a storage device (for instance a DRAM or another data memory), a filter, an integrated circuit (such as field-programmable gate array (FPGA), programmable array logic (PAL), generic array logic (GAL) and complex programmable logic devices (CPLDs)), a signal processing component, a power management component (such as a field-effect transistor (FET), metal-oxide-semiconductor field-effect transistor (MOSFET), complementary metal-oxide-semiconductor (CMOS), junction field-effect transistor (JFET), or insulated-gate field-effect transistor (IGFET), all based on semiconductor materials such as silicon carbide (SiC), gallium arsenide (GaAs), gallium nitride (GaN), gallium oxide (Ga2O3), indium gallium arsenide (InGaAs) and/or any other suitable inorganic compound), an optoelectronic interface element, a light emitting diode, a photocoupler, a voltage converter (for example a DC/DC converter or an AC/DC converter), a cryptographic component, a transmitter and/or receiver, an electromechanical transducer, a sensor, an actuator, a microelectromechanical system (MEMS), a microprocessor, a capacitor, a resistor, an inductance, a battery, a switch, a camera, an antenna, a logic chip, and an energy harvesting unit. However, other components may be embedded in the component carrier. For example, a magnetic element can be used as a component. Such a magnetic element may be a permanent magnetic element (such as a ferromagnetic element, an antiferromagnetic element, a multiferroic element or a ferrimagnetic element, for instance a ferrite core) or may be a paramagnetic element. However, the component may also be a IC substrate, an interposer or a further component carrier, for example in a board-in-board configuration. The component may be surface mounted on the component carrier and/or may be embedded in an interior thereof. Moreover, also other components, in particular those which generate and emit electromagnetic radiation and/or are sensitive with regard to electromagnetic radiation propagating from an environment, may be used as component.

In an embodiment, the component carrier is a laminate-type component carrier. In such an embodiment, the component carrier is a compound of multiple layer structures which are stacked and connected together by applying a pressing force and/or heat.

After processing interior layer structures of the component carrier, it is possible to cover (in particular by lamination) one or both opposing main surfaces of the processed layer structures symmetrically or asymmetrically with one or more further electrically insulating layer structures and/or electrically conductive layer structures. In other words, a build-up may be continued until a desired number of layers is obtained.

After having completed formation of a stack of electrically insulating layer structures and electrically conductive layer structures, it is possible to proceed with a surface treatment of the obtained layers structures or component carrier.

In particular, an electrically insulating solder resist may be applied to one or both opposing main surfaces of the layer stack or component carrier in terms of surface treatment. For instance, it is possible to form such a solder resist on an entire main surface and to subsequently pattern the layer of solder resist so as to expose one or more electrically conductive surface portions which shall be used for electrically coupling the component carrier to an electronic periphery. The surface portions of the component carrier remaining covered with solder resist may be efficiently protected against oxidation or corrosion, in particular surface portions containing copper.

It is also possible to apply a surface finish selectively to exposed electrically conductive surface portions of the component carrier in terms of surface treatment. Such a surface finish may be an electrically conductive cover material on exposed electrically conductive layer structures (such as pads, conductive tracks, etc., in particular comprising or consisting of copper) on a surface of a component carrier. If such exposed electrically conductive layer structures are left unprotected, then the exposed electrically conductive component carrier material (in particular copper) might oxidize, making the component carrier less reliable.

A surface finish may then be formed for instance as an interface between a surface mounted component and the component carrier. The surface finish has the function to protect the exposed electrically conductive layer structures (in particular copper circuitry) and enable a joining process with one or more components, for instance by soldering. Examples for appropriate materials for a surface finish are Organic Solderability Preservative (OSP), Electroless Nickel Immersion Gold (ENIG), Electroless Nickel Immersion Palladium Immersion Gold (ENIPIG), gold (in particular hard gold), chemical tin, nickel-gold, nickel-palladium, etc.

### Brief Description of the Drawings

The aspects defined above and further aspects of the invention are apparent from the examples of embodiment to be described hereinafter and are explained with reference to these examples of embodiment.
Figure 1 shows an antenna assembly, according to an exemplary embodiment of the invention.
Figure 2 shows a conventional antenna module.
Figure 3 shows a metal structure for the antenna assembly, according to an exemplary embodiment of the invention.
Figures 4 to 14 respectively show an antenna assembly, according to exemplary embodiments of the invention.
Figures 15A and 15B respectively show a top view on an antenna assembly, according to exemplary embodiments of the invention.
Figure 16 shows another top view on an antenna assembly, according to an exemplary embodiment of the invention.
Figures 17A and 17B respectively show a top view on an antenna structure, according to exemplary embodiments of the invention.
Figure 18 shows a detailed view of the conventional antenna module of Figure 2.
Figure 19 shows an antenna assembly with an electrically conductive interconnection, according to an exemplary embodiment of the invention.

### Detailed Description of the Drawings

**Figure 1** shows an antenna assembly 100, according to an exemplary embodiment of the invention. The antenna assembly 100 comprises two parts: a multilayer stack 110 (a component carrier) and an antenna structure 120, wherein the stack 110 is mounted on the antenna structure 120.

The stack 110 comprises in this embodiment a central core layer structure 113 sandwiched between an upper build-up layer structure (stack) 111 and a lower build-up layer structure (stack) 112. Optionally, the core layer structure may comprise an inorganic layer structure. During the manufacture process, the build-up may be done on the upper main surface and the opposed lower main surface of the core layer structure 113, e.g. by lamination of resin (in particular prepreg or ABF) layers. The stack 110 (in particular the build-ups 111, 112) comprises a plurality of electrically insulating layer structures 102 and a plurality of electrically conductive layer structures 104 alternating with each other. The build-ups 111, 112 may comprise at least three, in particular at least five, electrically conductive layer structures 104. The electrically conductive layer structures 104 are configured here as a redistribution layer structure that comprises traces/pads and blind vias.

At least one component 130, in Figure 1 two radio frequency integrated circuits, are embedded in the stack 110; specifically both components are embedded side-by-side (on the same vertical level) in the core layer structure 113. Preferably, the at least one component may comprise an RFIC. Alternatively, at the least one component 130 may be embedded in at least one of the build-ups 111, 112.

In a specific example, LiP is a specific structure belonging to the RF front-end, more specifically representing the interface between the chip, for example RFIC, and the antenna (structure) therefore mainly RFICs are concerned.

Through vias 117 (for transmitting the ground/power/data signals) extend through said core layer structure 113 and (electrically) interconnect the (electrically conductive layer structures 104 of the) upper stack 111 and the lower stack 112.

In an embodiment, the ground signal of the stack 110 is electrically coupled with the antenna structure 120, in particular with a conductive coating of the channel.

The redistribution layer structure can serve to translate small electric contacts of the embedded components 130 to larger electric contacts at the external surface of the stack 110. Additionally or alternatively, the redistribution layer may serve to transmit electromagnetic signals, preferably from the at least one component 130 to at least one, in particular at least two, coupling structures 115.

Portions of the electrically conductive layer structure 104 (of the lower build-up 112) are provided at the external side of the stack 110. Some of said portions are used to (electrically) interconnect the stack 110 and the antenna structure 120, in this example via solder balls 116. Alternatively, the interconnection of the stack 110 and the antenna structure 120 may be done by a sinter structure or nanowires (compare Figure 19). Yet, other portions of the electrically conductive layer structure 104 are configured to act as part of an electromagnetic wave coupling structure 115. In other words, these electromagnetic wave coupling structures 115 fulfill the function of a launcher, respectively.

The antenna structure 120 is also configured as a layer stack 123, yet the layers are not shown in Figure 1. Alternatively, the antenna structure 120 may be a block comprising only one layer. The antenna structure 120 comprises an opening 125 to a channel 121 that passes in the vertical direction (e.g. along the direction of gravity from top to bottom) through the antenna structure 120. The antenna can be seen as a sort of redistribution layer. The idea is to have entrance slot on the upper side in the area of the package which is to be redistributed to the other side of the antenna in a way, that at one side are the receiving antenna slots, and on the other side there are the transmitting antenna slots.

The channel 121 vertically extends through the entire antenna structure 120, here in an L-shape. Alternatively, the channel 121 may have irregular shapes, for example like a curve, connecting the top portion of the antenna structure 120 with the bottom portion of the antenna structure.

The stack 110 and the antenna structure 120 are arranged and connected to each other, so that a specific electromagnetic wave coupling structure 115 and a respective opening 125 to the channel 121 face each other (are aligned in the vertical direction and (at least partially) overlap). Additionally, the surface of the antenna structure having the opening 125 is spatially closer to the coupling structure 115 compared to the opposed surface (having at least one opening structure 122, in particular a slot antenna structure).

The extremity of the channel 121, opposed to the opening 125 faced to the electromagnetic wave coupling structure 115, comprises an opening structure 122, here two slots, configured as a wave emitter/receiver. Alternatively, the number of slots of the opening structure 122 may be one or larger than two, for example three, five, eight, forty-eight, sixty-four, or larger. There is further arranged an electrically conductive coupling layer structure 126 comprising at least one aperture 122 (in this example, the aperture is identical to the slot) being in communication with the opening 125 of the antenna structure 120. Additionally or alternatively, the electrically conductive layer structure 126 may comprise at least a further antenna element, for example a patch antenna or a dielectric resonator antenna.

The internal walls 124 of the channel 121 are coated by a shielding layer, preferably a metal. Additionally or alternatively, the internal walls 124 of the channel 121 may be free from coating material or may comprise a non-metal electrically conductive material. The channel 125 can be at least partially formed by a metal structure 300, which is further described in Figure 3. In an example, the channel 121 may at least partially be filled with a fluid, for example air, or an organic polymeric material having a low Dk/Df property. This may bring the advantage of transmitting electromagnetic waves having low losses.

The electromagnetic wave coupling structure 115 is configured here as a launcher comprising a conductive layer structure. In an example, the electromagnetic wave coupling structure 115 may comprise only one electrically conductive layer structure, for example comprising copper. In another example, the electromagnetic wave coupling structure 115 may comprise at least two electrically conductive layer structures, for example comprising copper and gold. Said conductive layer structure is provided on a second electrically insulating layer structure 118 of the stack 110, wherein the second electrically insulating layer structure 118 comprises a material different from that of the other electrically insulating layer structures 102, preferably a high frequency material. Alternatively, the second electrically insulating layer structure 118 may comprise a material similar, in particular the same, as the other electrically insulating layer structures 102.

It can be further seen that the launcher's 115 planar extension is smaller than the planar extension of the opening 125 of the antenna structure 120 and that the launcher 115 is directly facing the waveguide 125. Alternatively, launcher's 115 planar extension is the same, or bigger than the planar extension of the opening 125 of the antenna structure 120. Optionally, one launcher 115 may transmit electromagnetic waves towards/into at least two openings 125 of the antenna structure 120.

**Figure 3** shows a metal structure 300 for the antenna assembly 100, according to an exemplary embodiment of the invention. Said metal structure 300 can be applied to form the opening 125 and/or the channel 121 of the antenna structure 120. It can be seen that the metal structure 300 comprises:
i) a first metal layer structure 310 comprising a first recess 311 exposed to one first surface and defining a first external boundary profile 315, and
ii) a second metal layer structure 320 comprising a second recess 321 exposed to a second surface and defining a second external boundary profile 325.
The recesses 311 and 321 are hereby formed by an etching process. While some recesses 311, 312 are configured as blind holes, other recesses 314 are configured as through holes.

The first metal layer structure 310 and the second metal layer structure 320 are stacked to face each other, so that the first recess 311 and the second recess 321 define a common recess 330. The opening 125 and/or the whole channel 121 can be formed by such a common recess 330 of the metal structure 300. Since the metal structure comprise a plurality of common recesses 330 (with different shapes and sizes), a plurality of channels 121 can be provided (side-by-side) in the antenna structure.

In an exemplary embodiment, the first metal layer structure 310 and/or the second metal layer structure 320 is larger than 50 µm in the stack thickness direction (Z). Alternatively, the first metal layer structure 310 and/or the second metal layer structure 320 is larger than 100 µm in the stack thickness direction. The thickness of the first metal layer structure 310 and the thickness of the second metal layer structure 320 may be different relative to each other. Alternatively, they may be the same. The thickness of the metal structure 100 may be at least 100 µm, in particular at least 300 µm.

Figures 4 to 14 respectively show an antenna assembly 100, according to exemplary embodiments of the invention. Said antenna assemblies are comparable to the embodiment of Figure 1 yet showing specific (advantageous) modifications.

**Figure 4****:** in this embodiment, the dimension (length/width) of the wave coupling structure 115 (the launcher structure) (here a pad of the electrically conductive layer structure 104) is larger than other pads of the electrically conductive layer structure 104. Further, the extension of said launcher structure 115 is also larger than the extension of the corresponding opening 125 in the antenna structure 120.

**Figure 5****:** in this embodiment, the electromagnetic wave coupling structures 115 are arranged in respective electromagnetic wave coupling structure cavities 114. The electromagnetic wave coupling structures 115 are hereby configured as pads at the bottom of the respective cavity 114. Further, the sidewalls of the cavities 114 can be covered by a coating, e.g. a metal. Thereby, guiding/streamlining of the RF/HF signals can be improved.

**Figure 6****:** in this embodiment, the electromagnetic wave coupling structures 115 are shifted/offset with respect to their corresponding channel openings 121, 125 (launcher/waveguide misalignment). The electromagnetic wave coupling structures 115 and the corresponding channel openings 121, 125 still face each other, yet with a certain misalignment (illustrated by dotted lines along the vertical extension, which do not form a straight line together). Alternatively, the electromagnetic wave coupling structure 115 may be not misaligned with the corresponding channel opening 121 (see Figure 1).

**Figure 7****:** in this embodiment, there are two stacks 110a, 110b mounted on a common antenna structure 120. The stack (component carrier) part is hence modularized, i.e. two build-up structures are arranged side-by-side on the same antenna structure. The different modules 110a, 110b can be dedicated to different waveguides and/or different functionalities. In this manner, a more flexible assembly can be realized. Further, broken parts can be exchanged more easily.

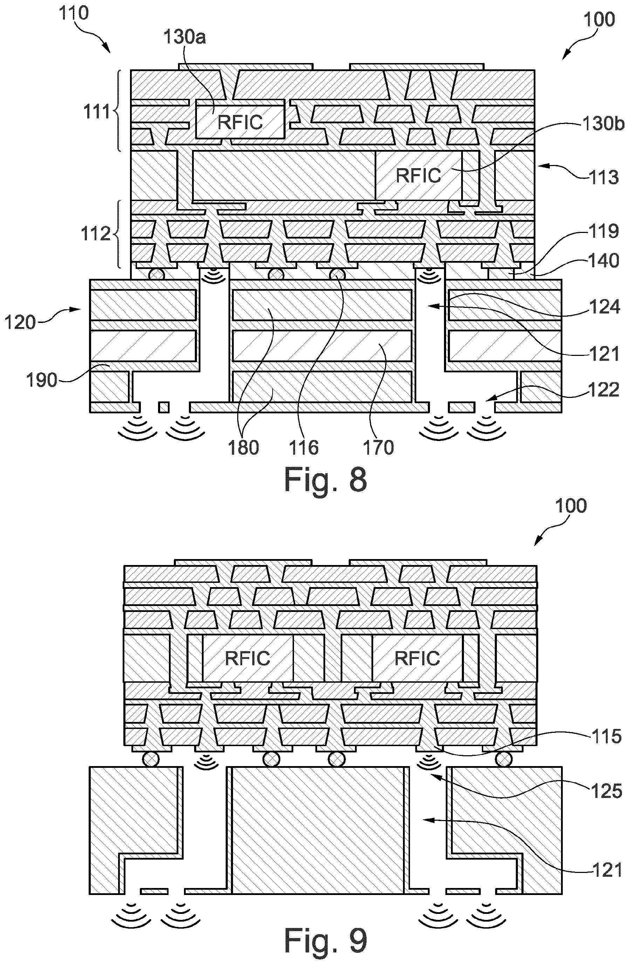

**Figure 8****:** in this embodiment, a first component 130a is embedded in the upper build-up structure 111, while a second component 130b is embedded in the core layer structure 113. The outermost layer of the lower build-up structure 112 of the stack 110 is coupled (interconnected) with the upper main surface of the antenna structure 120 through an intermediate layer structure 140. The intermediate layer structure 140 can be an electrically insulating structure, for example (low flow) prepreg and/or low Dk/Df material. Between exposed electric connections of the stack 110 and the antenna structure 120, there are arranged solder balls 116 and further interconnection structures 119, for example sinter paste (may be any metal paste), conductive paste, nanowires, or a thermal prepreg, for example. The connection structures 116/119 through the intermediate layer structure 140 can be applied for electric and/or thermal connection. Additionally, at portions, where the wave coupling structures 115 are located, the antenna assembly 100 may be free of intermediate layer structure 140.

Furthermore, it is shown in this example, that the antenna structure 120 comprises a further stack (a PCB-like structure) with three layers, specifically a core layer structure 170 sandwiched between two electrically insulating layer structures 180 (here prepreg material). Additionally, the antenna structure 120 may comprise at least one further electrically conductive layer structure 190.

In an exemplary embodiment, a ground and signal path is located in the stack up, in particular electrically connected from the stack 110 to the (metallic) sidewalls of the waveguide channel 121. Ground can be realized by the solder balls (BGA) 116. Ground and signal may be both located at an electrically conductive layer structure 104 of the stack 110. The embedded component 130 (e.g. a bare die) can (during embedding) already have an RDL on waver-level. In a specific example, the antenna structure comprises a plurality of layer structures, including one or more, e.g. three, core layer structures.

**Figure 9****:** in this embodiment, the dimension (length/width/extension/ diameter, etc.) of the wave coupling structure 115 is smaller than the dimension (length/width/extension, diameter, etc.) of the corresponding opening 125 in the antenna structure 120 and/or the channel 121. Compare Figure 1 (equal) and Figure 4 (larger). Further, the extension of the wave coupling structure 115 (here configured as a pad) is smaller than the extension of other pads of the electrically conductive layer structure 104.

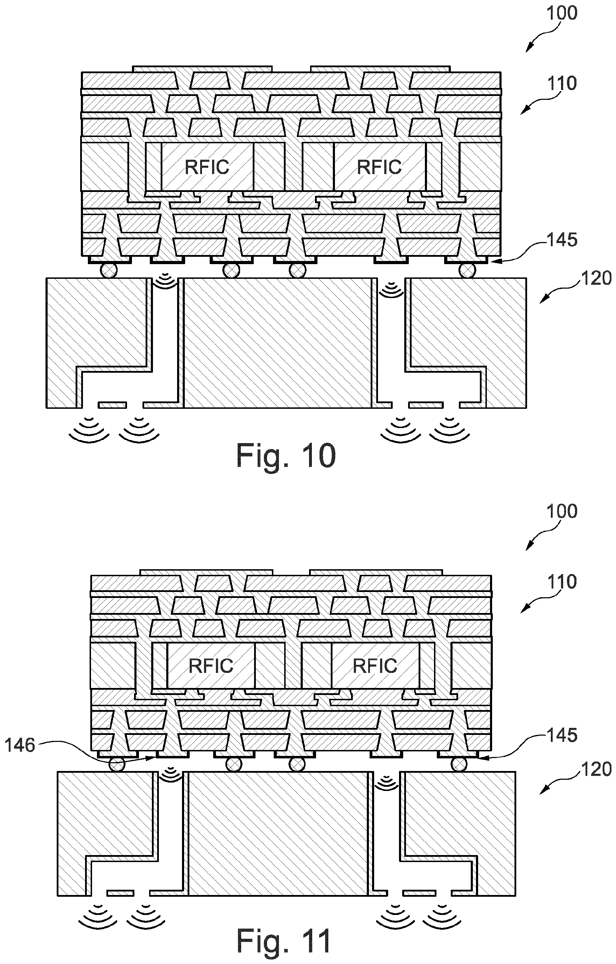

**Figure 10****:** in this embodiment, the electrically conductive layer structure 104 of the stack 110 comprises a surface finish 145, i.e. the (exposed) pads of said layer structure 104 are covered by surface finish material. Thus, also the electromagnetic wave coupling structures 115 are covered by said surface finish 145. In an example, at least one launcher 115 comprises an ENIG (or ENEPIG) surface finish 145.

**Figure 11****:** in this embodiment, the pads of the electrically conductive layer structure 104 of the stack 110 respectively comprise the surface finish 145, while the launchers 115 are respectively covered by a silicon-comprising protection layer 146 (e.g. a selective SiOx protective coating) exposed on the outer surface.

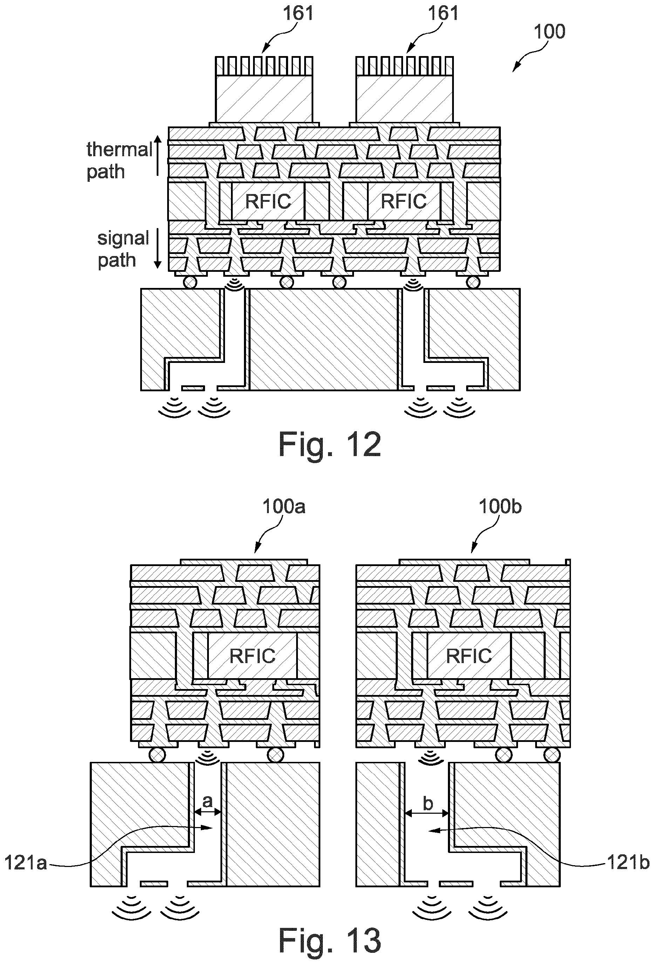

**Figure 12****:** in this embodiment, two heatsink 161 components are surface mounted to the upper main surface of the stack 110. In this example, the heatsink 161 components comprise heat fins to better distribute the transported heat to the environment. In this manner, heat produced by the embedded components 130 can be efficiently removed. The stack 110 may be divided thereby in two functional paths: i) a signal path that leads from the embedded components 130 to the antenna structure 120, and ii) a thermal path that leads from the embedded components 130 to the heatsink 161 components.

**Figure 13** shows an embodiment of an antenna system that comprises two (or more) antenna assemblies 100a, 100b. Each antenna assembly 100a, 100b comprises different properties, here regarding frequency. It can be seen that a first antenna assembly 100a comprises a first waveguide channel 121a with a first diameter a, while a second antenna assembly 100b comprises a second waveguide channel 121b with a second diameter b. In this manner, different functionalities, in particular regarding specific frequencies, may be realized efficiently and straightforward.

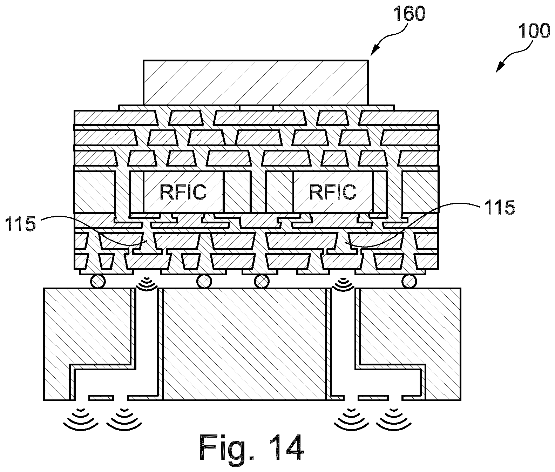

**Figure 14****:** in this embodiment, a further component 160 is surface mounted to the upper main surface of the stack 110 (compare Figure 12). Further, the electromagnetic wave coupling structures 115 are not exposed (outermost layer) at the bottom main surface of the stack 110, but are instead embedded in the stack 110.

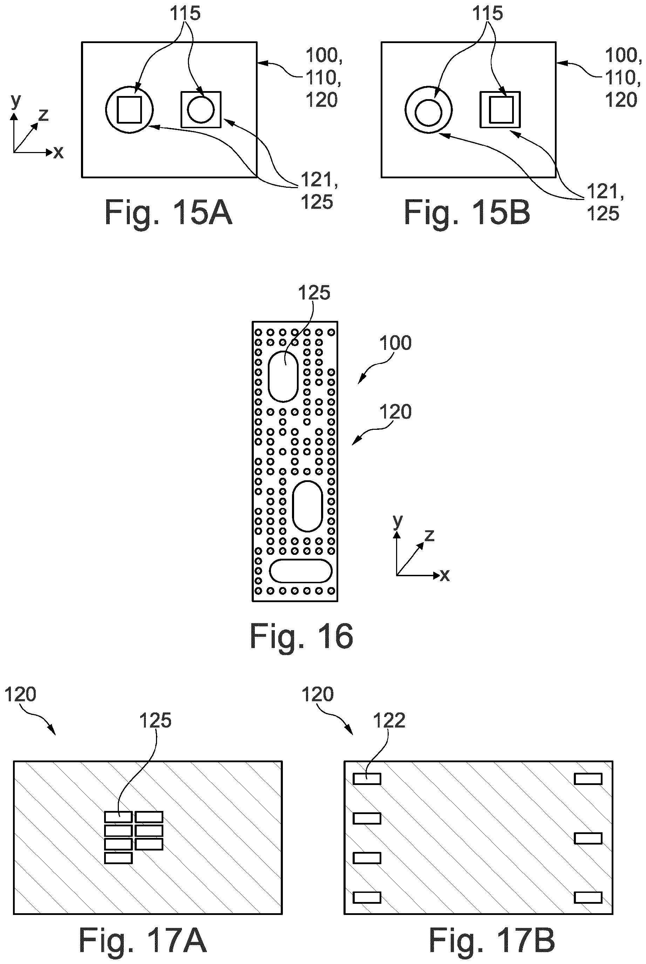

Figures 15A and 15B respectively show a top view on an antenna assembly 100, according to exemplary embodiments of the invention.

**Figure 15A****:** in this top view, there can be seen wave coupling structures 115 of the stack 110 facing respective channel openings 121, 125 of the antenna structure 120. While the left wave coupling structure 115 comprises a rectangular shape, the right wave coupling structure 115 comprises a circular shape. The corresponding channel openings 121, 125 comprise a different shape, respectively. While the left opening 125 comprises a circular shape, the right opening 125 comprises a rectangular shape.

**Figure 15B****:** in this embodiment, the wave coupling structures 115 and the corresponding channel openings 121, 125 comprise the same shape. In other words, the left wave coupling structure 115 and the left opening 125 comprise both a circular shape, while the right wave coupling structure 115 and the right opening 125 comprise both a rectangular shape. Additionally, the coupling structures 115 of the stack 110 are misaligned with the respective channel (openings) 121, (125).

In both examples, the wave coupling structures 115 comprise smaller extension/dimension than the corresponding openings 125.

**Figure 16** shows a top view on the antenna structure 120, according to an exemplary embodiment of the invention. A plurality of openings 125 can be seen, which have in this example an elliptic shape. While the upper channel openings 125 are configured for a transmitter functionality, the lower channel openings 125 are configured for a receiver functionality. Furthermore, the circle-shape elements around the openings 125 are vertical interconnections (vias), which can be configured for shielding the openings 125.

Figures 17A and 17B respectively show a top view on an antenna structure 120, according to exemplary embodiments of the invention.

**Figure 17A****:** this is a top view on the upper main surface (facing the stack 110 for signal entrance) of the antenna structure 120, which shows the openings 125. Seven slots corresponding to seven RF channels, respectively, are shown. There can be e.g. three transmitting channels and four receiving channels. In an example, the number of channels can be significantly increased, e.g. to 64 or more.

**Figure 17B****:** this is a top view on the lower main surface (facing the environment) of the antenna structure 120, which shows the opening structures (apertures, slots) 122. As can be seen in Figure 1, these are connected within the antenna structure 120 through channels 121 to the respective opening 125. Hereby, opening 125 and corresponding opening structures 122 are not at the same position. Seven slots correspond to seven RF channels 121. Inside the antenna structure 120, three transmitting channels are routed in a way that the escape slot is on one side (on the right side) of the antenna structure 120; whereas the four receiving channels are routed in a way that they are located on the opposite (left side) of the antenna structure 120.

**Figure 19** shows an antenna assembly 100 with an electrically conductive interconnection 119, according to an exemplary embodiment of the invention. Thus, instead of the solder balls (BGA) 116 of other examples, here electrically conductive interconnection elements 119 such as sinter paste (may be any metal paste), conductive paste, nanowires, or a thermal prepreg. Like in Figure 12, the stack 110 can be divided in a thermal path (functionality) and a signal path (functionality). The electrically conductive interconnection may support electric interconnection between stack 110 and antenna structure 120, for example with respect to a ground connection.

### Reference signs

- 100: Antenna assembly
- 102: Electrically insulating layer structure
- 104: Electrically conductive layer structure
- 110: Stack
- 111: Upper build-up
- 112: Lower build-up
- 113: Core layer structure
- 114: Electromagnetic wave coupling structure cavity
- 115: Electromagnetic wave coupling structure
- 116: Connection structure, solder ball
- 117: Electrically conductive vertical connection
- 118: Second electrically insulating layer structure
- 119: Conductive interconnection paste
- 120: Antenna structure
- 121: Channel, waveguide
- 122: Opening structure, aperture, slot
- 123: Antenna structure body, antenna structure stack
- 124: Internal wall
- 125: Opening
- 126: Coupling electrically conductive layer structure
- 140: Intermediate layer structure
- 145: Surface finish
- 146: Silicon-comprising protection layer
- 160: Further component
- 161: Heatsink

- 300: Metal structure
- 310: First metal layer structure
- 311: First recess
- 314: Through recess
- 315: First external boundary profile
- 320: Second metal layer structure
- 321: Second recess
- 325: Second external boundary profile
- 330: Common recess

## Claims

1. An antenna assembly (100) comprising:
a stack (110) comprising:
at least one electrically conductive layer structure (104) and at least one electrically insulating layer structure (102),
wherein at least a portion of said electrically conductive layer structure (104, 115) is provided at the external side of the stack (110) and is configured to act at least as part of an electromagnetic wave coupling structure (115); and
a component (130), at least partially embedded in the stack (110), and coupled to said electromagnetic wave coupling structure (115); and
an antenna structure (120), comprising an opening (125) to a channel (121) passing through the antenna structure (120);
wherein the stack (110) and the antenna structure (120) are connected, so that the electromagnetic wave coupling structure (115) and the opening (125) to the channel (121) face each other.

2. The antenna assembly (100) according to claim 1,
wherein the channel (121) vertically extends through the entire antenna structure (120).

3. The antenna assembly (100) according to claim 1 or 2,
wherein the extremity of the channel (121), opposed to the opening (125) faced to the electromagnetic wave coupling structure (115), comprises an opening structure (122), in particular a slot, configured as a wave emitter or wave receiver.

4. The antenna assembly (100) according to claim 2 or 3,
wherein the extremity of the channel (121), opposed to the opening (125) faced to the electromagnetic wave coupling structure (115), comprises an electrically conductive coupling layer structure (126) comprising at least one aperture (122) being in communication with the opening (125) of the antenna structure (120).

5. The antenna assembly (100) according to one of the preceding claims,
wherein the internal walls (124) of the at least opening (125) on the antenna structure (120) and/or the channel (121) are coated by an electrically conductive material, in particular a metal, more in particular a metal having a magnetic permeability in the range from 10⁻⁶ H/m to 10⁻⁵ H/m, preferably between 1.1*10⁻⁶ and 5*10⁻⁶.

6. The antenna assembly (100) according to one of the preceding claims, further comprising a metal structure (300), wherein said metal structure (300) comprises:
a first metal layer structure (310) comprising a first recess (311) exposed to one first surface and defining a first external boundary profile (315); and
a second metal layer structure (320) comprising a second recess (321) exposed to a second surface and defining a second external boundary profile (325);
wherein the first metal layer structure (310) and the second metal layer structure (320) are stacked to face each other, so that the first recess (311) and the second recess (321) define a common recess (330);
wherein the channel (121) is at least partially formed by the common recess (330) of the metal structure (300).

7. The antenna assembly (100) according to one of the preceding claims,
wherein the electromagnetic wave coupling structure (115) comprises a launcher structure configured for transmitting electromagnetic waves from the stack (110) to the antenna structure (120),
in particular from launcher (115) to the channel (121).

8. The antenna assembly (100) according to one of the preceding claims,
wherein the electromagnetic wave coupling structure (115) comprises an external layer structure of a material not affecting the electromagnetic waves,
in particular a hydrophobic material.

9. The antenna assembly (100) according to one of the preceding claims,
wherein the stack (110) is directly connected with the antenna structure (120),
in particular by at least one of an adhesive, a solder material, a through solder structure, a connecting element, in particular a nanowire or a pillar.

10. The antenna assembly (100) according to one of the preceding claims, wherein the stack (110) and the antenna structure (120) are connected by a connection structure (116), in particular solder balls or nanowires.

11. The antenna assembly (100) according to one of the preceding claims,
wherein the antenna structure (120) has a planar extension greater than that of the stack (110).

12. The antenna assembly (100) according to one of the preceding claims,
wherein a plurality of stacks (110) is connected to one common antenna structure (120).

13. The antenna assembly (100) according to one of the preceding claims,
wherein the surface of the stack (110) opposite to the surface connected with the antenna structure (120) comprises at least one connecting portion, said at least one connecting portion being configured to be connected to an external component and/or to a further stack.

14. An antenna system, comprising:
a common further stack; and
one or more antenna assembly (100), according to one of the preceding claims, mounted on the common further stack.

15. A method of manufacturing an antenna assembly (100), the method comprising:
providing a stack (110) comprising: at least one electrically conductive layer structure (104) and at least one electrically insulating layer structure (102), wherein at least a portion of said electrically conductive layer structure (104, 115) is provided at the external side of the stack (110) and
is configured to act at least as part of an electromagnetic wave coupling structure (115);
at least partially embedding a component (130) in the stack (110) and coupling the component (130) to said electromagnetic wave coupling structure (115);
providing an antenna structure (120), comprising an opening (125) to a channel (121) passing through the antenna structure (120); and
connecting the stack (110) and the antenna structure (120), so that the electromagnetic wave coupling structure (115) and the opening (125) to the channel (121) face each other.
